(19) **Europäisches Patentamt**

**European Patent Office**

**Office européen des brevets**

(11) **EP 1 527 664 B1**

(12) **EUROPEAN PATENT SPECIFICATION**

(45) Date of publication and mention
of the grant of the patent:
**11.01.2006 Bulletin 2006/02**

(51) Int Cl.:
**H05K 13/08** *(2006.01)*

(21) Application number: **03765339.1**

(86) International application number:
**PCT/JP2003/009224**

(22) Date of filing: **22.07.2003**

(87) International publication number:
**WO 2004/010759 (29.01.2004 Gazette 2004/05)**

(54) **COMPONENT MOUNTING ORDER OPTIMIZATION METHOD, COMPONENT MOUNTING ORDER OPTIMIZATION PROGRAM, RECORDING MEDIUM FOR THE PROGRAM, AND COMPONENT MOUNTING APPARATUS USING THE METHOD**

VERFHAREN ZUR OPTIMIERUNG DER BESTÜCKUNGSFOLGE, PROGRAMM ZUR OPTIMIERUNG DER BESTÜCKUNGSFOLGE, INFORMATIONSAUFZEICHNUNGSMEDIUM DAFÜR UND VORRICHTUNG ZUR DURCHFÜHRUNG DES VERFAHRENS

PROCEDE D'OPTIMISATION D'ORDRE DE MONTAGE DE COMPOSANTS, PROGRAMME D'OPTIMISATION D'ORDRE DE MONTAGE DE COMPOSANTS, SUPPORT D'ENREGISTREMENT POUR LE PROGRAMME, ET DISPOSITIF DE MONTAGE DE COMPOSANTS UTILISANT CE PROCEDE

(84) Designated Contracting States:
**DE GB**

(30) Priority: **23.07.2002 JP 2002213983**

(43) Date of publication of application:
**04.05.2005 Bulletin 2005/18**

(73) Proprietor: **MATSUSHITA ELECTRIC INDUSTRIAL CO., LTD.**
**Kadoma-shi, Osaka 571-8501 (JP)**

(72) Inventors:
• **YAMASAKI, Akihito**
**Fukuoka 830-0001 (JP)**
• **MAENISHI, Yasuhiro**
**Kofu-shi, Yamanashi 400-0043 (JP)**
• **YOSHIDA, Ikuo**
**Kyoto 611-0012 (JP)**
• **KINDO, Toshiki**
**Yokohama-shi, Kanagawa 227-0044 (JP)**
• **SHIDA, Takehiko**
**Yokohama-shi, Kanagawa 244-0813 (JP)**

(74) Representative: **Eisenführ, Speiser & Partner**
**Patentanwälte Rechtsanwälte,**
**Postfach 31 02 60**
**80102 München (DE)**

(56) References cited:
**EP-A- 0 727 924          US-A- 6 006 425**
**US-B1- 6 289 582**

**Description**

TECHNICAL FIELD

The present invention relates to, for example what is called a rotary type component mounting apparatus in which component holders hold and mount components while rotating along a circumference, and also to a method for optimizing a component mounting order to optimize a component mounting operation carried out by the component mounting apparatus, a program for optimizing a component mounting order to carry out the optimization method, and a computer readable recording medium with the component mounting order optimization program recorded.

BACKGROUND ART

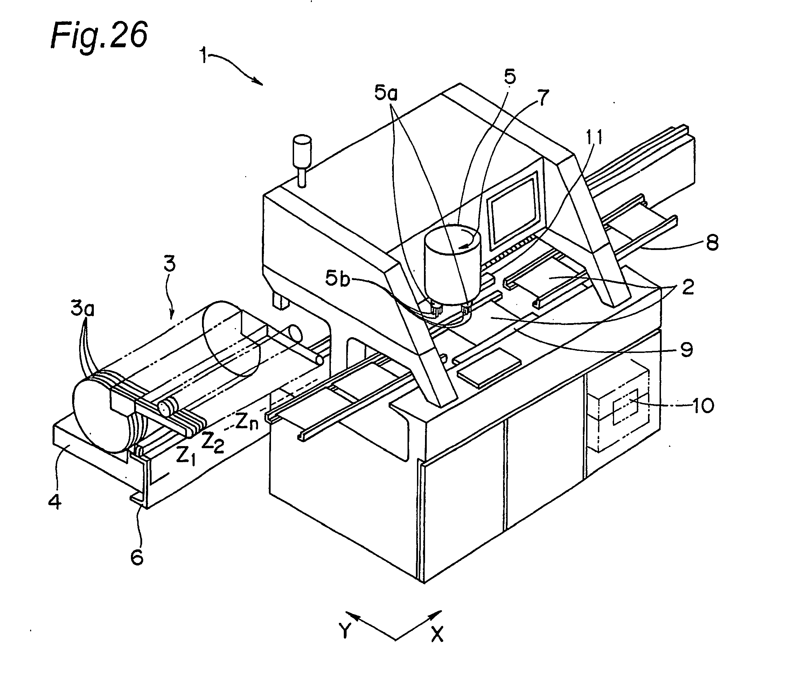

There is the so-called rotary type component mounting apparatus 1 shown in Fig. 26. The component mounting apparatus 1 has roughly an orthogonal table 9, a component supply unit 3, a supply table 4, a component holding device 5, a circuit board transfer device 8, a controller 10, and a component recognizer 11. The orthogonal table 9 is a table for holding a circuit board 2 and positioning the circuit board 2 to mount electronic components onto the circuit board 2, which is movable in X and Y-directions orthogonal to each other. The component supply unit 3 is constituted of generally called reel type parts cassettes 3a each with a mechanism for supplying electronic components continuously from a reel where a tape with the electronic components stored therein is wound, having a plurality of the parts cassettes 3a arranged side by side along the X-direction as indicated in the drawing. The supply table 4 with the component supply unit 3 equipped detachably thereto is movable in the X-direction along a rail 6 extending in the X-direction. To the supply table 4 are allotted unique numbers (referred to as Z-numbers hereinafter) respectively for recognizing positions in the X-direction where the parts cassettes 3a are loaded.

In the component holding device 5, a plurality of mounting heads 5a and a plurality of nozzles 5b equipped with each mounting head 5a for holding electronic components by suction are fitted to the so-called rotary head type cylindrical rotary body. The component holding device 5 rotates in a direction about a rotational center axis as indicated by an arrow 7 although being prevented from moving in the X and Y-directions. Each of the nozzles 5b is movable up and down in a direction in which the nozzle extends. The circuit board transfer device 8 is a device for carrying a circuit board 2 into the component mounting apparatus 1 and carrying the circuit board 2 out of the component mounting apparatus 1. The controller 10 controls the operation of each of the above constituent parts to control an electronic component mounting operation to circuit board 2. The component recognizer 11 is a device for imaging a holding posture of the electronic component at nozzle 5b before the electronic component after held by nozzle 5b from the parts cassette 3a is mounted to the circuit board 2.

The electronic components are mounted in the following manner in the component mounting apparatus 1 constituted as above. Since the component holding device 5 is unmovable in the X and Y-directions as depicted hereinabove, the supply table 4 moves the parts cassette 3a having desired electronic components to be mounted to the circuit board 2 to a component holding position where the electronic components can be sucked by the nozzles 5b. Meanwhile, the orthogonal table 9 moves in the X and Y-directions so that the nozzle 5b holding the electronic component is positioned to desired mounting position on the circuit board 2. The nozzle 5b of the component holding device 5 rotates in the direction about the axis along the arrow 7 after holding the electronic component from the positioned parts cassette 3a. The component recognizer 11 images the holding posture in a halfway of the rotation. The nozzle 5b moves to above the mounting positions by the rotation. The component holding device 5 lowers the nozzle 5b to mount the electronic component to the mounting position. After the mounting, nozzle 5b rotates again along the arrow 7 to return to above the parts cassette 3a. The above operation is carried out for the nozzles 5b at each of the mounting heads 5a, whereby each of the electronic components is mounted onto the circuit board 2.

In the above component mounting apparatus 1, since the component holding device 5 rotates at a fixed point without moving in the X and Y-directions, the rotation of the nozzles 5b to above the mounting positions after the nozzles 5b hold electronic components from the parts cassettes 3a, and the rotation operation of the nozzles 5b until the nozzles 5b return to above the parts cassettes 3a after the electronic components are mounted are determined by mechanical characteristics of the component holding device 5. However, the rotational speed of the holding device 5 is required to be different for electronic components to be held by the nozzles 5b so as to prevent trouble of drop of the electronic components from the nozzles 5b, and the like. Moreover, it is necessary for the supply table 4 to move a desired parts cassette 3a to the component holding position so that the nozzle 5b can hold the desired electronic component as described above.

As such, in the conventional art, parts cassettes 3a for supplying electronic components for which the rotational speed of the component holding device 5 is to be equal are grouped to be a group A, a group B, ... for every rotational speed, thereby shortening a cycle time required for mounting the electronic components. In addition, parts cassettes 3a in each group are arranged at the supply table 4 so that the parts cassettes 3a with a larger number of components to be supplied are positioned to be closer to the component holding position.

In the above conventional arrangement, since the parts cassettes 3a in each group are arranged at the supply table 4 without being related to the mounting positions on the circuit board 2 where the electronic components are to be mounted, and therefore a longer time is eventually consumed in some cases from holding the component to mounting the component.

US-A-6 289 582 describes a component mounting order optimization method in which the component supply parts are arranged in accordance with the mounting sequence of the components to be mounted on the circuit board.

DISCLOSURE OF INVENTION

The present invention is devised to solve the aforementioned problem and has for its object to provide a component mounting order optimization method, a component mounting order optimization program, a computer readable recording medium with a component mounting order optimization program recorded, and a component mounting apparatus whereby the mounting time can be shortened as compared with the conventional art.

In order to accomplish the above objective, the present invention is constituted as described herein.

According to a first aspect of the present invention, there is provided a component mounting order optimization method executed before carrying out a component mounting operation in which a component is held from one component supply part disposed at a component holding position among a plurality of component supply parts arranged in parallel and arranged movably for supplying components, is transferred to a component mounting position, and is mounted to a mounting point on a circuit board disposed at the component mounting position by moving in X-axis and Y-axis directions, the method comprising:

representing the mounting point (173) in a three dimensional space which is given that a Z-number showing a location of each component supply part (103a) is expressed by a Z-axis and a plane of the circuit board (2) is expressed by the X and Y-axes; and

determining an arrangement of the component supply parts (103a) and a component mounting order on the circuit board (2) so that a component mounting path connecting the mounting points (173) in the three dimensional space becomes the shortest.

The Method may further comprise:

optimizing an arrangement of the component supply parts with position information of the mounting points taken into account; and then

optimizing a component mounting path to the circuit board under the optimized arrangement of the component supply parts.

The above method of the first aspect may be designed so that the optimization of the arrangement of the component supply parts is carried out by temporarily arranging the component supply parts and correcting the temporary arrangement before optimizing the component mounting path.

The above method of the first aspect may be designed so that the temporary arrangement in optimizing the arrangement of the component supply parts is executed by obtaining a product of variances for each of X and Y-coordinate values and Z-values showing locations of the component supply parts in terms of the mounting points of the circuit board while the Z-value is changed, and then obtaining the arrangement of the component supply parts which makes the variance product smaller.

The above method of the first aspect may be designed so that the arrangement which makes the variance product smaller is obtained by executing:

a first process of obtaining a first variance product for a first arrangement of the component supply parts;

a second process of obtaining a second variance product for a second arrangement different from the first arrangement; and

a third process of comparing the first variance product and the second variance product with each other and setting the smaller one as a new first variance product,

thereby obtaining a much smaller new first variance product by repeating the second process and the third process subsequently.

The above method of the first aspect may be designed so that for correcting the temporary arrangement in optimizing the arrangement of the component supply parts, after the component supply parts are temporarily arranged by obtaining the smaller variance product, the location of a second component supply part is changed on a basis of a distance between a reference mounting position on the circuit board where the component supplied from a first component supply part adjacent to the component holding position is to be mounted and an object mounting position on the circuit board where the component supplied from the second component supply part other than the first component supply part is to be mounted, thereby further optimizing the arrangement of the component supply parts.

The above method of the first aspect may be designed so that the changing of the location of the second component supply part comprises:

obtaining each of the distances while the second component supply part is sequentially changed; and
arranging the second component supply part which makes the distance shortest adjacent to the first component supply part.

The above method of the first aspect may be designed so that the component mounting path is optimized by selecting two mounting paths for connecting two mounting points among mounting paths, recombining the two mounting paths, and selecting the path having a shorter mounting path length through comparison between before and after the recombination, thereby executing the optimization.

The above method of the first aspect may be designed so that in order to reflect the mounting path optimized by the recombination of mounting paths to the mounting order, after the optimization, a mounting order for the mounting points which constitute the optimized mounting path is changed.

The above method of the first aspect may be designed so that the component supply parts are rearranged after the optimized mounting path is reflected to the mounting order, whereby the component mounting path is optimized and reflected to the mounting order.

According to a second aspect of the present invention, there is provided a component mounting order optimization program for making a computer execute a component mounting order optimization method in a component mounting operation in which a component is held from one component supply part disposed at a component holding position among a plurality of component supply parts arranged in parallel and movable for supplying components, is transferred to a component mounting position, and is mounted to a mounting point on a circuit board disposed at the component mounting position by moving in X-axis and Y-axis directions, the program comprising:

a procedure of representing the mounting point (173) in a three dimensional space which is given that a Z-number showing a location of each component supply part (103a) is expressed by a Z-axis and a plane of the circuit board (2) is expressed by the X and Y-axes; and
a procedure of determining an arrangement of the component supply parts (103a) and a component mounting order on the circuit board (2) so that a component mounting path connecting the mounting points (173) in the three dimensional space becomes the shortest.

The program may further comprise:

a procedure of optimizing an arrangement of the component supply parts with position information of the mounting points taken into account; and
a procedure of optimizing a component mounting path to the circuit board under the optimized arrangement of the component supply parts.

According to a third aspect of the present invention, there is provided a computer readable recording medium with a program according to the second aspect of the invention stored thereon.

According to a fourth aspect of the present invention, there is provided a component mounting apparatus comprising:

a component supply unit having a plurality of supply parts arranged in parallel for supplying components, for supplying components from one of the supply parts positioned to a component holding position;
a component shift device having a component holder, for transferring the component holder between the component holding position and a component mounting position, holding components supplied from the supply parts by the component holders and mounting the components to mounting points on a circuit board at the component mounting position;
an orthogonal table for holding the circuit board and moving the circuit board in X and Y-axes directions, thereby locating the mounting points to the component mounting position; and
a controller for optimizing a mounting operation of the components to the circuit board from the supply parts, which includes an arrangement optimizing part (181) for representing the mounting point (173) in a three dimensional space which is given that a Z-number showing a location of each component supply part (103a) is expressed by a Z-axis and a plane of the circuit board (2) is expressed by the X and Y-axes, and a mounting path optimizing part (182) for determining an arrangement of the component supply parts (103a) and a component mounting order on the circuit board (2) so that a component mounting path connecting the mounting points (173) in the three dimensional space becomes the shortest. The arrangement optimizing part preferably carries out for optimization an arrangement of the supply parts with position information of the mounting points taken into account, and a mounting path preferably carries out optimization part for optimizing a component mounting path to the circuit board under the optimized arrangement of the supply parts.

The above apparatus of the fourth aspect may be designed so that the arrangement optimizing part obtains a product of three variances of each of X and Y-coordinate values and Z-values showing locations of the supply parts while the Z-value is changed in terms of the mounting points on the circuit board, and obtains the arrangement of the component supply parts which makes the variance product smaller.

The above apparatus of the fourth aspect may be designed so that the arrangement optimizing part obtains the arrangement which makes the variance product smaller by obtaining a first variance product for a first arrangement of the supply parts, obtaining a second variance product for a second arrangement different from the first arrangement, comparing the first variance product and the second variance product with each other to set the smaller one as a new first variance product, and obtaining a much smaller variance product as a new first variance product by repeating the comparison.

The above apparatus of the fourth aspect may be designed so that the arrangement optimizing part further optimizes the arrangement of the supply parts, after optimizing the arrangement of the supply parts by obtaining the smaller variance product, caused by changing a location of a second supply part on a basis of a distance between a reference mounting position where the component supplied from a first supply part adjacent to the component holding position is to be mounted and an object mounting position where the component supplied from the second supply part other than the first supply part is to be mounted.

The above apparatus of the fourth aspect may be designed so that for changing the location of the second supply part, the distance is obtained while the second supply part is sequentially changed and the second supply part which makes the distance shortest is arranged adjacent to the first supply part.

The above apparatus of the fourth aspect may be designed so that the mounting path optimizing part optimizes by selecting two among mounting paths for connecting two mounting points, recombining the two mounting paths, and selecting the path having a shorter mounting path length through comparison between before and after the recombination.

The above apparatus of the fourth aspect may be designed so that the mounting path optimizing part changes a mounting order of mounting points which constitute a new mounting path after the recombination of mounting paths, in accordance with the new mounting path.

The above apparatus of the fourth aspect may be designed so that the controller optimizes the component mounting path again by rearranging the supply parts after the component mounting path is optimized.

According to the component mounting order optimization method of the first aspect, the component mounting order optimization program of the second aspect, the recording medium of the third aspect and the component mounting apparatus of the fourth aspect of the present invention, there are provided the component supply unit, the component shift device and the controller, whereby the mounting path to the circuit board is optimized under the arrangement of component supply parts installed in the component supply unit after the arrangement is optimized by the controller while position information of mounting points of the circuit board is taken into account. Since the position information of the mounting points is taken into account when the arrangement of the component supply parts is to be obtained, wasteful mounting paths are reduced and the mounting time can be shortened in comparison with the conventional art in which the mounting path only on the circuit board is optimized.

A product of variances is used as a means for optimizing the arrangement of the component supply parts, whereby the distribution of mounting points in three dimensions including the arrangement of the component supply parts can be concentrated easily.

After the arrangement of the component supply parts is obtained with the use of the variance product, the arrangement of the component supply parts is corrected on the basis of the mounting path length to be taken when the electronic components are mounted from the component supply parts disposed by the arrangement. This correction operation enables obtaining a more appropriate arrangement of the component supply parts, reducing wasteful mounting paths more and shortening the mounting time.

The mounting path to the circuit board is optimized under the optimized arrangement of the component supply parts. Wasteful mounting paths are thus reduced, so that the mounting time can be shortened. Further, for optimizing the mounting path, two unit paths are recombined and the path having a shorter mounting path length through comparison between before and after the recombination is adopted, thus facilitating detecting the much shorter path.

The arrangement of the component supply parts is considered again after the mounting path is optimized as above, whereby the mounting path is optimized again, and the mounting time can be shortened furthermore.

BRIEF DESCRIPTION OF DRAWINGS

These and other aspects and features of the present invention will become clear from the following description taken in conjunction with the preferred embodiments thereof with reference to the accompanying drawings, in which:

Fig. 1 is a flow chart showing a component mounting order optimization method according to one preferred embodiment of the present invention;
Fig. 2 is a diagram explanatory of the operation of step 100 in Fig. 1;
Fig. 3 is a diagram explanatory of the operation of step 100 in Fig. 1 and having a partial changeover from Fig. 2;
Fig. 4 is a diagram explanatory of the operation of step 200 in Fig. 1, namely, a diagram of each mounting point seen in plan from an arrow direction of Fig. 3;
Fig. 5 is a flow chart explanatory of the operation of step 100 in Fig. 1 in detail;
Fig. 6 is a diagram explanatory of the operation of step 200 in Fig. 1, namely, explanatory of a relation between an arrangement of parts cassettes and mounting points of a circuit board;
Fig. 7 is a flow chart explanatory of the operation of step 200 in Fig. 1 in detail;
Fig. 8 is a diagram supplementally explanatory of the operation of step 207 in Fig. 7;
Fig. 9 is a flow chart explanatory of the operation of step 300 in Fig. 1 in detail;
Fig. 10 is a flow chart explanatory of the operation of step 307 in Fig. 9 in detail;
Fig. 11 is a flow chart explanatory of the operation of step 307 in Fig. 9 in detail;
Fig. 12 is a diagram specifically explanatory of recombination of mounting paths depicted in Figs. 10 and 11;
Fig. 13 is a diagram specifically explanatory of the recombination of mounting paths depicted in Figs. 10 and 11;
Fig. 14 is a diagram specifically explanatory of the recombination of mounting paths depicted in Figs. 10 and 11;
Fig. 15 is a diagram showing a mounting path before the recombined by operations in Figs. 10 and 11;
Fig. 16 is a diagram showing a mounting path after recombined with the mounting path shown in Fig. 15, explanatory of the necessity of reflecting the mounting path to a mounting order;
Fig. 17 is a diagram in which a mounting path after recombined with the mounting path of Fig. 16 is reflected to the mounting order;
Fig. 18 is a diagram showing a relation between the mounting order and mounting points shown in Fig. 17;
Fig. 19 is a flow chart explanatory of the operation of step 400 in Fig. 1 in detail;
Fig. 20 is a flow chart explanatory of the operation of step 400 in Fig. 1 in detail;
Fig. 21 is a perspective view of a component mounting apparatus for carrying out the component mounting order optimization method of the embodiment shown in Fig. 1;
Fig. 22 is a plan view showing a component supply unit, a component shift device and the like parts in Fig. 21 more in detail;
Fig. 23 is a diagram of an example of an arrangement of parts cassettes in the component supply unit of Fig. 21;
Fig. 24 is a diagram explanatory of relations from a view point of control at a controller shown in Fig. 21;
Fig. 25 is a diagram explanatory of an effect when the component mounting order optimization method of the embodiment shown in Fig. 1 is carried out;
Fig. 26 is a perspective view of a conventional component mounting apparatus; and

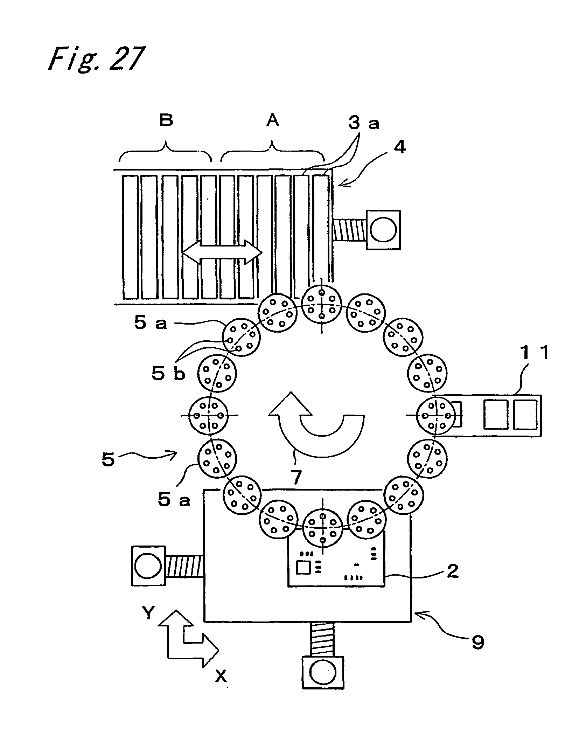

Fig. 27 is a plan view showing a component supply unit, a component shift device and the like parts of Fig. 26 more in detail.

BEST MODE FOR CARRYING OUT THE INVENTION

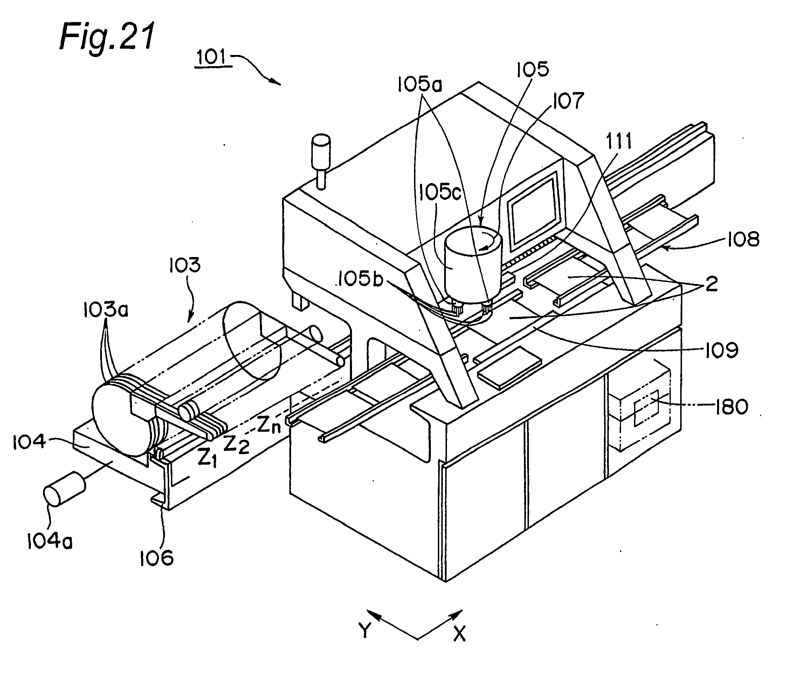

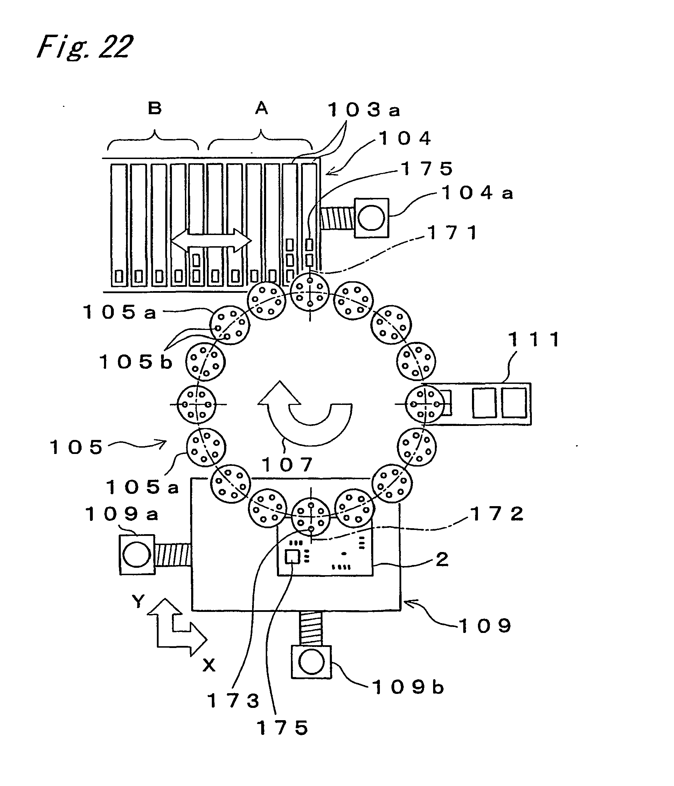

A component mounting order optimization method, a component mounting order optimization program, a computer readable recording medium with a component mounting order optimization program recorded, and a component mounting apparatus which embody the present invention will be described in detail below with reference to the attached drawings. The above component mounting order optimization program is a program for making a computer carry out the component mounting order optimization method, and the component mounting apparatus is an apparatus for executing the component mounting order optimization method thereby carrying out a component mounting operation. Like constituent parts are designated by like reference numerals through the drawings.
The component mounting order optimization is to optimize a component mounting order so as to make a route for mounting components shortest.
The component mounting apparatus according to one embodiment will be described first. As indicated in Figs. 21 and 22, the component mounting apparatus 101 of the present embodiment is the so-called rotary type in which component holders installed to a component shift device 105 to be described below mount components while rotating on a circumference. A fundamental configuration of the apparatus 101 has a component supply unit 103, a supply table 104, the component shift device 105, and a controller 180. The component mounting apparatus 101 is further provided with a circuit board transfer device 108, an orthogonal table 109, and a component recognizer 111.

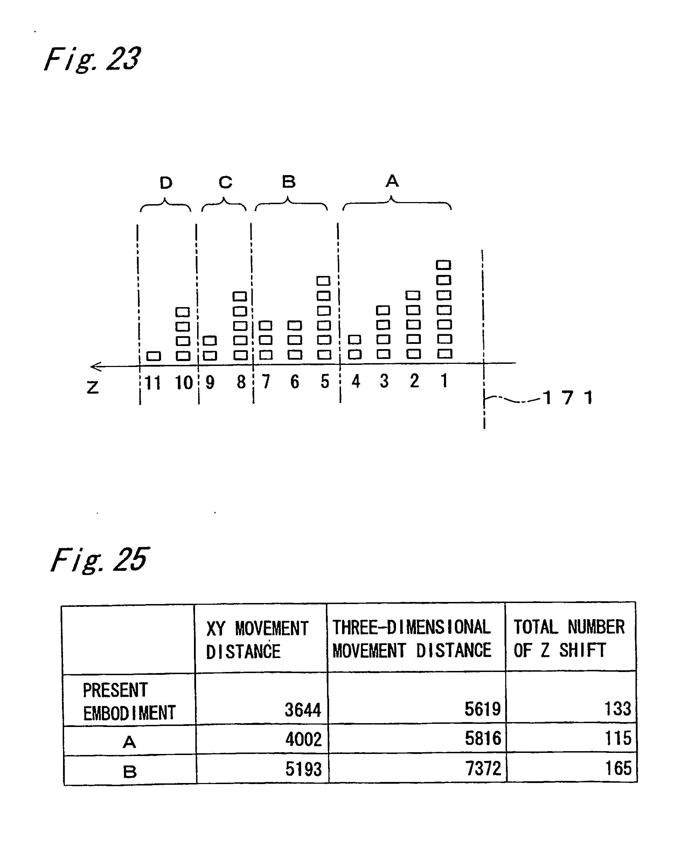

The component supply unit 103 has so-called reel type parts cassettes 103a having a mechanism for continuously supplying electronic components 175 from a reel where a tape with the electronic components stored therein is wound, and the supply table 104 where the parts cassettes 103a are detachably loaded and arranged in parallel in an X-axis direction. The parts cassette 3a corresponds to an example functioning as a supply part. In order to execute the component mounting order optimization method of the embodiment, it is premised that at least two parts cassettes 3a are installed. Kinds of electronic components to be supplied from parts cassettes 103a may differ for each parts cassette, or electronic components of the same kind may be supplied from a plurality of parts cassettes 103a. It does not matter what kind of electronic components is supplied from each parts cassette 103a. According to the present embodiment as well, parts cassettes 103a for supplying electronic components 175 to be rotated at the same rotational speed at the component shift device 105 are grouped into a group A, a group B, ... for every rotational speed as shown in Fig. 23 and thus arranged at the supply table 104. However, an arrangement of the parts cassettes 103 in each group is determined by an arrangement optimization method for the parts cassettes 103 to be detailed later, and the parts cassettes 103 in each group are arranged on the basis of the determination. The supply table 104 can be moved, for example, by a drive unit 104a having a ball screw mechanism along a rail 106 extending in the X-axis direction, positioning one parts cassette 103a which is to supply desired electronic components 175 to the component shift device 105, to a component holding position 171 as shown in Fig. 22. The supply table 104 has the aforementioned Z-numbers allotted thereto as unique numbers to recognize the position in the X-axis direction where each parts cassette 103 is loaded.

The component shift device 105 is the so-called rotary head type having nozzles 105b for holding electronic components 175 by suction. The nozzle 105b corresponds to an example exerting the function of the component holder. Specifically, the component shift device 105 has a plurality of mounting heads 105a arranged at a circumferential edge part of a cylindrical rotary body 105c, with a plurality of nozzles 105b installed for each mounting head 105a. The component shift device 105 rotates the rotary body 105c in a direction about a rotational center axis indicated by an arrow 107 although it prevents the rotary body from moving in the X-axis and a Y-axis directions. Each nozzle 105b is movable up and down in a direction along its axis. In the thus constituted component shift device 105, through the above rotation of the rotary body 105c, nozzles 105b are rotated between a component holding position 171 and a component mounting position 172 positioned on the circumference of the mounting head 105a, whereby the electronic component 175 supplied by the parts cassette 3a positioned to the component holding position 171 is held by the nozzle 105b and mounted to a mounting point 173 of a circuit board 2 at the component mounting position 172.

The circuit board transfer device 108 is a device extending along the X-axis direction for carrying the circuit board 2 to the orthogonal table 109 and carrying the circuit board 2 out of the component mounting apparatus 101. The orthogonal table 109 is a table for holding the circuit board 2 carried in via the circuit board transfer device 108 and positioning the mounting point 173 on the circuit board 2 to the component mounting position 172 for an operation of mounting the electronic component 175 onto the circuit board 2. The orthogonal table 109 can be moved in mutually orthogonal X-axis and Y-axis directions by, for example, two drive units 109a and 109b each having a ball screw mechanism.

The component recognizer 111 is a device disposed below a rotation route of nozzles 105b of the component shift device 105 for imaging a posture of the electronic component 175 held by the nozzle 105b before the electronic component is mounted onto the circuit board 2 after the electronic component is held by the nozzle 105b from the parts cassette 103a.

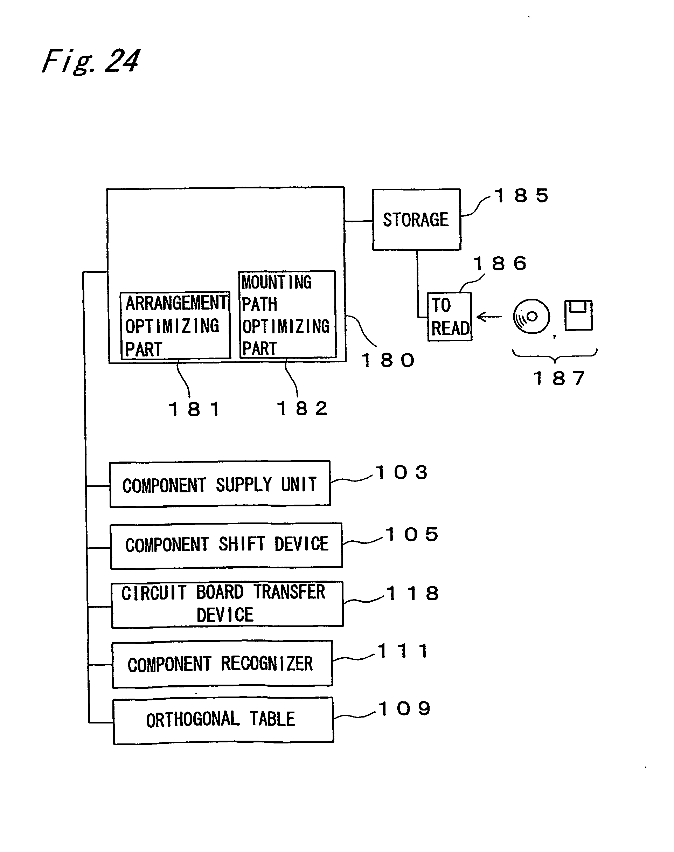

The controller 180 controls, as indicated in Fig. 24, operations of each of the above constituent parts thereby controlling the operation of mounting electronic components onto the circuit board 2 in accordance with the so-called NC-program including electronic component data, circuit board data, mounting position data, mounting operation order data and the like stored in a storage 185. Furthermore, as one of operations characteristic of the present embodiment, the controller 180 carries out an optimization operation for the component mounting order with the arrangement of parts cassettes 103a at the supply table 104 taken into account, that is, an operation for obtaining a path whereby a mounting path length to the circuit board 2 becomes minimum while the arrangement of the parts cassettes 103a is taken into account. A program for carrying out the optimization operation for the component mounting order may be stored in the storage 185 beforehand, or may be recorded into a recording medium 187 such as a CD-ROM and read out by a read device 186 installed in the component mounting apparatus 101. Alternatively, the program may be downloaded via a communication line to the storage 185.

Operations in the component mounting apparatus 101 constituted as above will be described hereinafter. Each of the following operations is controlled by the controller 180. The mounting operation itself carried out by the component mounting apparatus 101 is not different from that in the conventional art and therefore will be omitted from the description below. Herein, the operation controlled and carried out by the controller 180 for optimizing the component mounting order with the arrangement of parts cassettes 103a taken into consideration will be primarily discussed, and yet a brief description of the component mounting operation including the optimization operation will be provided. The optimization operation for the component mounting order is an operation to be preliminarily carried out before a start of the component mounting operation so as to obtain an optimized component mounting order. The optimized component mounting order thus obtained is stored in the storage 185 and is executed as one program within the NC-program by the controller 180.

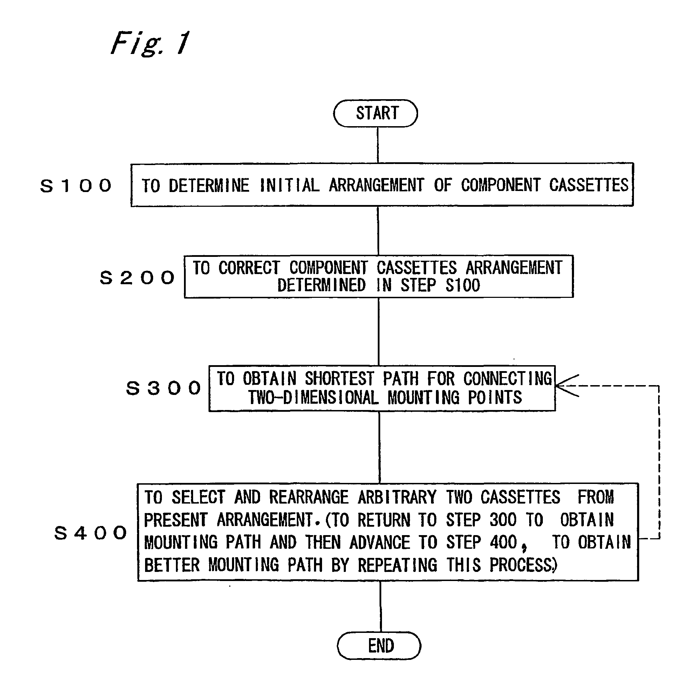

The optimization method for the component mounting order schematically consists of steps (indicated by "S" in the drawings) 100-400 as indicated in Fig. 1. Essential operations are steps 100-300 although it is preferred to carry out step 400.

First, step 100 will be described.

At step 100, the arrangement or layout when each parts cassette 103a is loaded onto the supply table 104 of the component supply unit 103 is obtained while position information of the mounting points 173 of the circuit board 2 is taken into account when an initial arrangement of the parts cassettes 103a is obtained. Similar to the conventional example, parts cassettes 103a are grouped for every rotational speed at the component shift device 105 in the present embodiment as well, and therefore the above arrangement or layout implies obtaining an arrangement of parts cassettes 103a within each group.

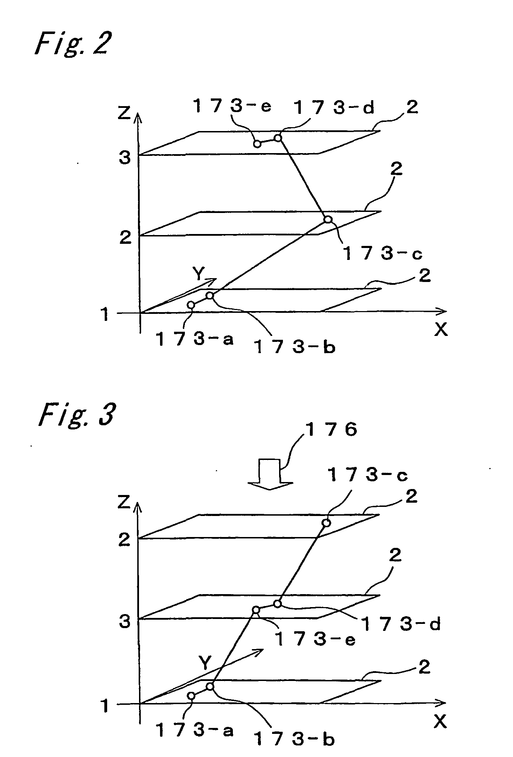

As a method of obtaining the arrangement with the position information of the mounting points 173 of the circuit board 2 being taken into account, an "analysis of variance" used in statistical processes is employed in the embodiment. Specifically, the method will be depicted here in relation to the case wherein, for example, electronic components supplied from the parts cassette 103a disposed at the Z-number of "1" on the supply table 104 are mounted to mounting points 173-a and 173-b on the circuit board 2, an electronic component from the parts cassette 103a disposed at the Z-number of "2" is mounted to a mounting point 173-c on the circuit board 2, and electronic components from the parts cassette 103a disposed at the Z-number of "3" are mounted to mounting points 173-d and 173-e on the circuit board 2, as shown in Fig. 2. In this case, the mounting operation to each of the mounting points 173-a to 173-e can be represented in three dimensions as shown in Fig. 2 given that the Z-number showing the location of each parts cassette 103a is expressed by the Z-axis of a three dimensional space and a plane of the circuit board 2 is expressed by the X and Y-axes. As is apparent from the comparison between Fig. 2 and Fig. 3 plotted in the same fashion as Fig. 2, the mounting path length becomes shorter if the parts cassette 103a of the Z-number "2" is replaced with the parts cassette 103a of the Z-number "3", making the mounting operation smoother.

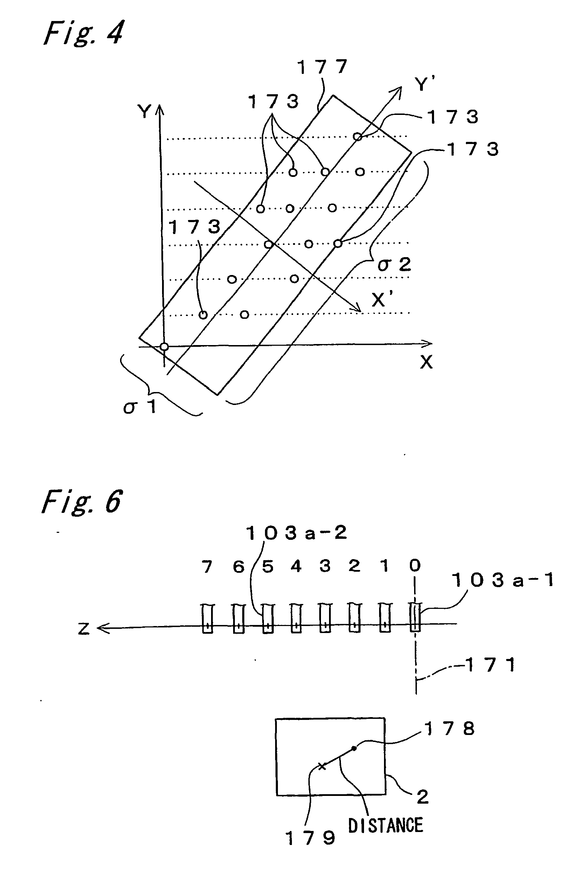

In the meantime, in order for simplifying the description using the three dimensions, it is possible to plot each mounting point 173 two dimensionally as indicated in Fig. 4 if three circuit boards 2 are seen together from a direction perpendicular to the circuit board 2, i.e., from an arrow 176 direction in Fig. 3. Fig. 4 is a conceptual diagram not exactly showing mounting points of Fig. 2 or 3. As will be made clear from Fig. 4 and the description related to the above replacement of Z-numbers "2" and "3", the mounting path length is reduced more and the mounting operation is made smoother when the mounting points 173 are concentrated as much as possible when seen in the two dimensional illustration as Fig. 4.

In the present embodiment, taking notice of this fact, the present embodiment adopts the concept of the aforementioned variance as a way of quantitatively evaluating a distribution spread of the mounting points 173, namely, a way of concentrating the distribution of the mounting points 173. Considering a rectangular region 177 which surrounds the distribution of mounting points 173, in terms of two dimensions with reference to Fig. 4, an appropriate arrangement of parts cassettes 103a at the supply table 104 is obtained so that a multiplied value of a variance $\sigma1$ of mounting points 173 in a longitudinal direction of the rectangular region 177 and a variance $\sigma2$ of mounting points 173 in a lateral direction becomes as small as possible.

In practice, the multiplied value of three variances corresponding to the number of dimensions is obtained for the distribution of mounting points 173 in three dimensions which is constituted of X and Y-coordinate values of mounting points on the circuit board 2, and the Z-number, i.e., Z-coordinate values in the arrangement of parts cassettes 103a. Specifically, a product of three variances is obtained by obtaining the variance for X-coordinate values of mounting points on the circuit board 2, the variance for Y-coordinate values of mounting points, and the variance for Z-coordinate values of mounting points. According to the present embodiment, the product of three variances is obtained with the utilization of a determinant of a three dimensional variance matrix as follows:

## Expression 1

$$\upsilon_{ij} = (1/N) \sum\nolimits_{a=r}^{N} (Xi(a) - <Xi>)(Xj(a) - <Xj>)$$

wherein Xi(a) is an i element of the mounting point No. (a), that is, any of x, y and z-coordinate values, and $<Xi>$ is a mean value of the i element. The matrix $\upsilon$ is a symmetric matrix. As the three dimensional variance matrix is taken note as above, i and j are digits from 1 to 3 and $\upsilon_{ij}$ itself is a substance digit in the matrix which is expressed by:

Expression 2

$$\{ v11 \quad v12 \quad v13 \}$$

$$\{ v21 \quad v22 \quad v23 \}$$

$$\{ v31 \quad v32 \quad v33 \}$$

i is a number of row of the matrix and j is a number of column in the matrix. Each $\upsilon$ value is calculated according to the Expression 1 and substituted for the above matrix, whereby the determinant of the matrix is obtained. In other words, the determinant is obtained according to the following Expression 3:

Expression 3

$$Determinant= v11\,v22\,v33 + v13\,v21\,v32 + v31\,v12\,v23$$

$$- v13\,v22\,v31 - v11\,v23\,v32 - v12\,v21\,v33$$

wherein $\upsilon11$, $\upsilon12$ and the like as the substance figures in the matrix become the elements of the matrix.

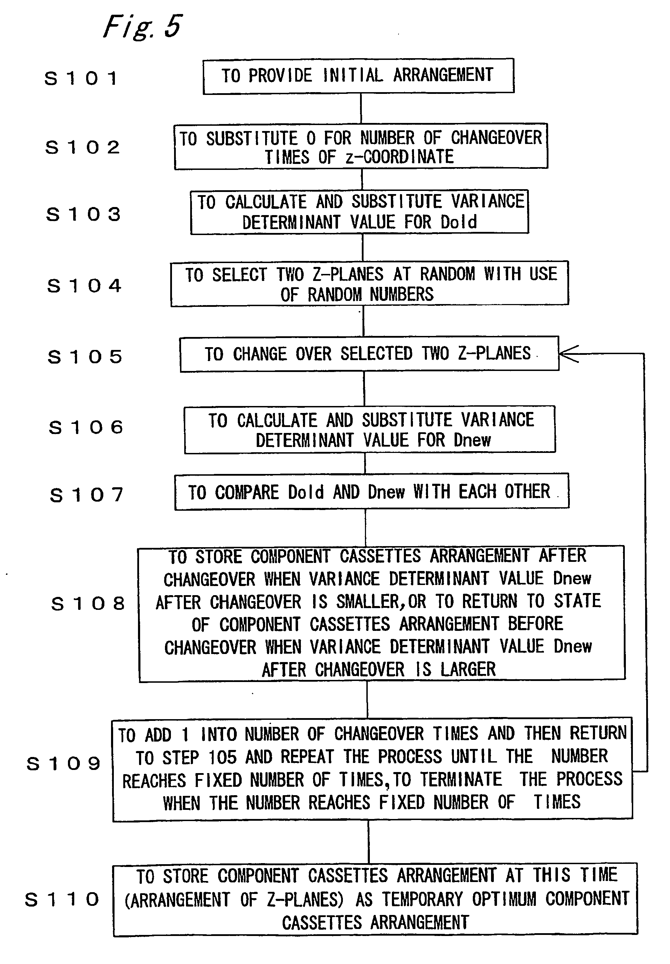

The operation for obtaining the arrangement of parts cassettes 103a which makes the above variance small, namely, the operation of step 100 will be more fully described now with reference to Fig. 5. Operations in steps 100 and 200 for obtaining the arrangement are controlled and executed by an arrangement optimizing part 181 included in the controller 180.

First at step 101, parts cassettes 103a are loaded and arranged onto the supply table 104 for each group so that the group of a higher rotational speed at the component holding device 105 is brought to a place with a smaller Z-number. Since the parts cassettes 103a are rearranged as will be described later because of the initial arrangement, parts cassettes 103a within each group may be arranged in any order without being determined in the stage of step 101. At step 102, the number of changeover times in the arrangement of parts cassettes 103a on the supply table 104 is set to 0 as an initial value. At step 103, the above variance determinant value is obtained. Specifically, variances are obtained corresponding to the X- and Y-coordinate values of the mounting points 173 and Z-numbers showing the location of parts cassettes 103a, and then a product of the three variances is obtained and substituted for Dold.

At step 104, two parts cassettes 103a to be changed over in the arrangement are selected with the use of random numbers. At step 105, the selected parts cassettes are replaced with each other. At step 106, the variance determinant value is obtained for the parts cassettes 103a after the changeover at step 105, and is substituted for Dnew.

Next at step 107, the Dold and Dnew values are compared with each other. At step 108, when the Dnew value is smaller than the Dold value, in other words, the arrangement becomes better, information on the arrangement of the parts cassettes 103a after the changeover is stored. On the other hand, when the Dnew value is larger than the Dold value, that is, the arrangement is made worse, information is returned to original arrangement information of parts cassettes 103a before the changeover.

At next step 109, 1 is added to the number of changeover times of the arrangement and the process returns to step 105. Steps 105-109 are repeated until the number of changeover times reaches a set value. The process is terminated at a time point when the number of changeover times becomes the set value. Arrangement information of parts cassettes 103a when the process is terminated is stored as temporary arrangement information into the storage 185 at step 110.

By carrying out the operation of step 100, such nature is observed on the average that the X or Y-coordinate values of the mounting points 173 or its linear sum increase or decrease in accordance with increase of the Z-numbers of the parts cassettes 103a. The nature is characteristic of the Z-direction arrangement of parts cassettes 103 which is obtained by the algorithm for carrying out step 100.

Step 200 will be depicted.

In step 200, the arrangement is optimized by adding correction to the temporary arrangement of parts cassettes 103a obtained in step 100. In component mounting operation according to the above temporary arrangement, a phenomenon occurs that the mounting paths at mounting points in the vicinity of the distribution of mounting points 173 such as shown in Fig. 4 elongate. The phenomenon is unfavorable from a view point of forming the path as short as possible. The operation of step 200 makes the correction to reduce this path loss. Since the temporary arrangement of parts cassettes 103a within the groups is obtained for each group in step 100 as described hereinabove, the correction operation in step 200 is also carried out to the temporary arrangement for each group.

Concept of the correction operation in step 200 is such that, while a starting point of the path which is, for example, one of the mounting points of the components supplied from the parts cassette 103a arranged at Z=0 is fixed, different parts cassettes 103 which supply the components to be mounted to nearest mounting points within an X, Y-plane of the circuit board 2 with respect to the one mounting point are changed to be Z=1 sequentially from the one having a larger Z-coordinate value. The path loss to be generated in the vicinity of the distribution is reduced by repeating the above operation. Expressing in different words, the location of a second parts cassette 103a-2 is changed on the basis of a distance between a reference mounting position 178 of the circuit board 2 where the electronic component supplied from a first parts cassette 103a-1 present at the component holding position 171 or adjacent to the position 171 is to be mounted and an object mounting position 179 of the circuit board where the component supplied from the second parts cassette 103a-2 other than the first parts cassette 103a-1 is to be mounted. The arrangement of the parts cassettes is more optimized accordingly. To change the location of the second parts cassette 103a-2, the above distances are obtained sequentially while the second parts cassette 103a-2 for obtaining the distance is sequentially changed, and the second parts cassette 103a-2 which makes the distance shorter is brought next to the first parts cassette 103a-1.

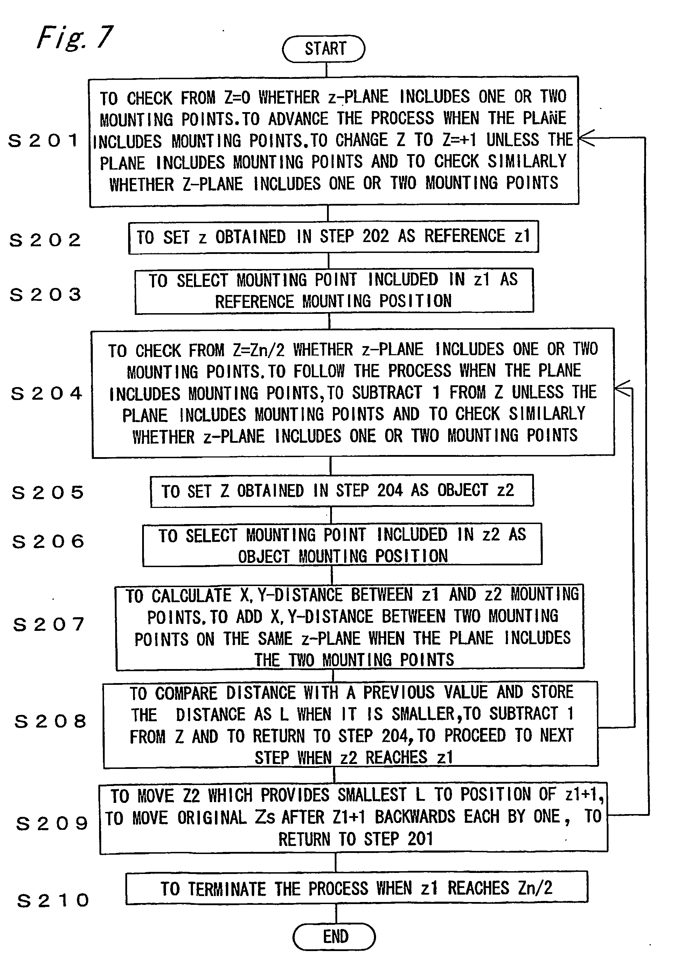

A concrete algorithm in step 200 in the embodiment for carrying out the above operation will be described with reference to Fig. 7. The operation in step 200 is carried out separately to a part of 0 to n/2 and a part of (n+1) /2 to n of the parts cassettes 103a arranged in one group with Z-numbers of 0-maximum n. The part of 0 to n/2 will be described by way of example below.

The reason for carrying out step 200 separately to every half of the group is caused by the so-called retracement technique by step 200, whereby the distribution can be made small by carrying out the retracement with regard to each reference parts cassette 103a at the two regions.

At step 201, it is checked sequentially from the parts cassette 103a having the Z-number, i.e., the parts cassette 103a arranged at Z-coordinate value of 0 whether or not the parts cassette 103a contains one or two electronic components to supply. Step 201 advances to next step 202 when the parts cassette 103a has the electronic component(s), whereas the above operation is carried out again by increasing the Z-coordinate value one by one when the parts cassette 103a contains no electronic component. At step 202, the Z-coordinate value of the parts cassette 103a where the presence of one or two electronic components is confirmed first at step 201 is made a reference Z1. At step 203, the mounting point 173 of the electronic component supplied from the parts cassette 103a disposed at the reference Z1 is made the reference mounting position 178.

At step 204, it is checked sequentially from the parts cassette 103a having the Z-coordinate value of n/2 whether or not the parts cassette 103a contains one or two electronic components to supply. The step goes to step 205 when the parts cassette 103a contains electronic component(s). Without electronic component(s) contained, the presence/absence of electronic component (s) is confirmed in the same manner as above by reducing the Z-coordinate value one by one. At step 205, the Z-coordinate value of the parts cassette 103a where the presence of one or two components to be supplied is confirmed first at step 204 is made an object Z2. At step 206, the mounting point 173 of the electronic component supplied from the parts cassette 103a arranged at the object Z2 is made the object mounting position 179.

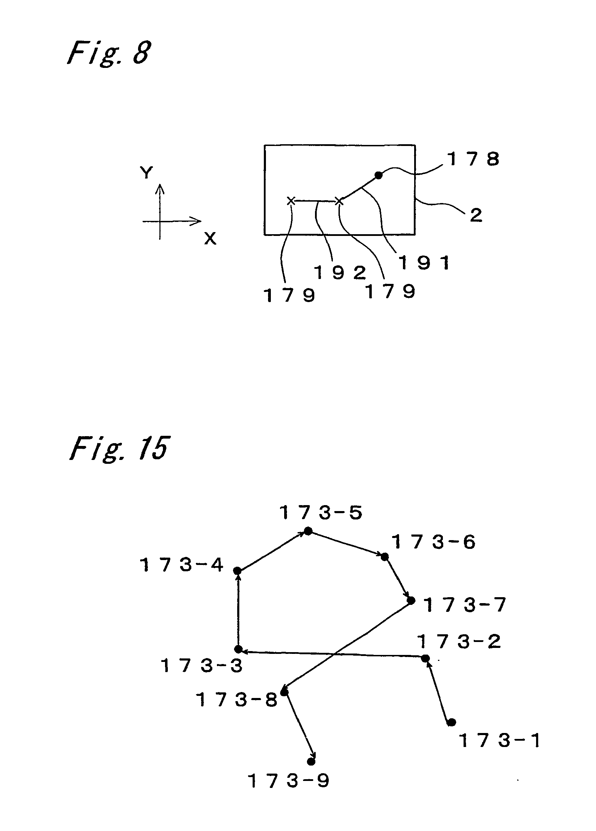

At step 207, the distance on the X, Y-plane between the reference mounting position 178 and the object mounting position 179 is obtained. When there are two electronic components to be supplied from the same parts cassette 103a, as shown in Fig. 8, a second distance 192 on the X, Y-plane between two object mounting positions 179 is added to a first distance 191. At step 208, the distance value obtained at step 207 is stored as L, and 1 is subtracted from the Z-coordinate value to return to step 204. The step moves on to step 209 when the Z-coordinate value of the object Z2 becomes the Z-coordinate value of the reference Z1. At step 208, if there is already the obtained distance value L, an existing distance value Lo is compared with the distance value Ln obtained this time, and the present distance value Ln is rendered the distance value L only when the present distance value Ln is smaller than the existing distance value Lo.

At step 209, the parts cassette 103a present at the Z-coordinate value of the object Z2 which provides the smallest distance value L is arranged to a Z-coordinate position of the reference Z1+1. Parts cassettes 103a originally arranged at the reference Z1+1 position and the Z-coordinate positions thereafter are moved backward each by one position. Then the step returns to step 201. The correction operation is terminated at step 210 when the reference Z1 reaches n/2.

The arrangement of parts cassettes 103a disposed at the remaining (n+1) /2 to n of Z-coordinate positions is corrected in the same manner as above.

By the foregoing operation, an arrangement having a high possibility of providing the shortest mounting path can be obtained for parts cassettes 103a in one group. The arrangement of parts cassettes 103 obtained by the above operation will be named an initial component cassettes arrangement ZO1.

Similar to the above, an arrangement having a high possibility of providing the shortest mounting path is obtained for every group of parts cassettes 103a.

Step 300 will be described hereinafter.

In step 300, such path is obtained that reduces the component mounting path to the circuit board 2 more under the arrangement of parts cassettes 103a optimized in the above steps 100 and 200. In the present embodiment, a concept of a mounting order is introduced because an optimum mounting path is considered with the arrangement of parts cassettes 103a separated. The mounting order provides an order or sequence in which the components are mounted to the mounting points 173. A three-dimensional mounting path is determined when the mounting order is combined with the arrangement of parts cassettes 103a. That is, the mounting path changes although the mounting order does not change when the arrangement of parts cassettes 103a is changed.

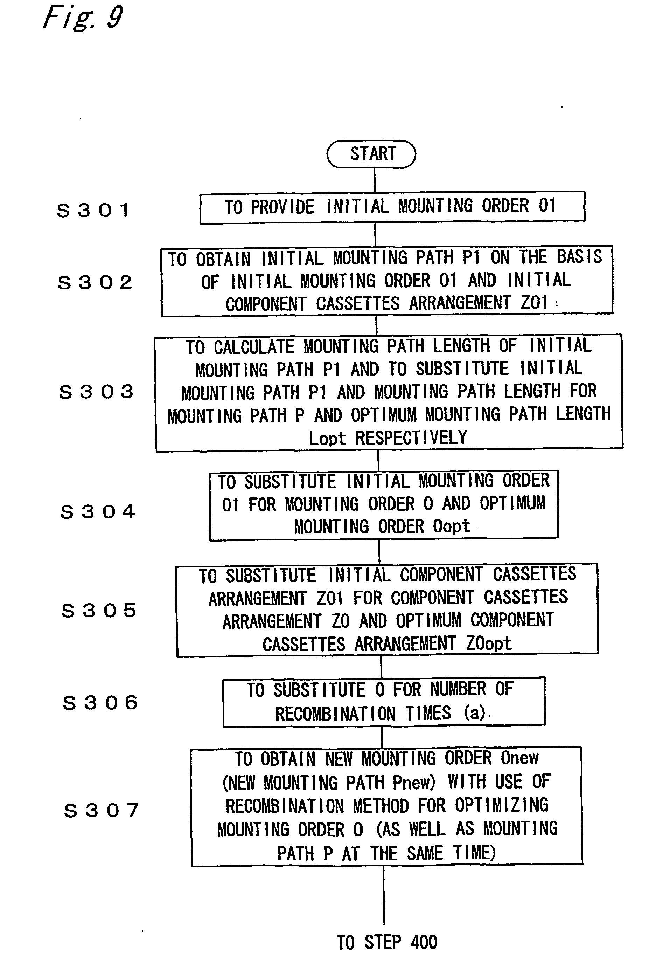

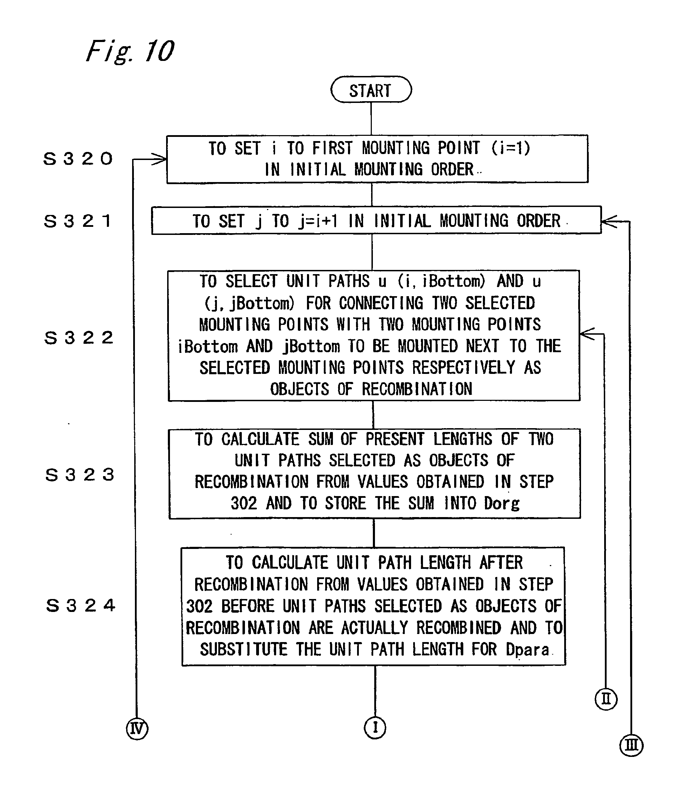

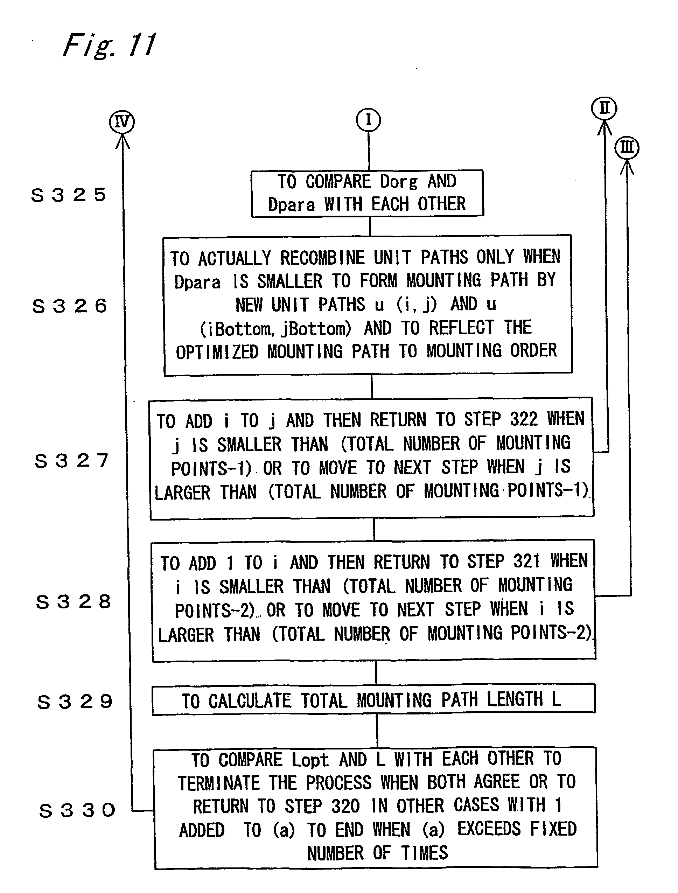

According to the operation in the embodiment in step 300, two are selected from mounting paths for connecting two mounting points 173 and then the two mounting paths are recombined, thereby selecting the path having a shorter mounting path length through comparison between before and after the recombination, whereby the mounting path is optimized. A concrete algorithm in the embodiment in step 300 will be described below with reference to Figs. 9-11. Figs. 10 and 11 are halves of a diagram divided because of a sheet size, which continue at marks I-IV. The operation in step 300 for obtaining the component mounting path is controlled and carried out by a mounting path optimizing part 182 included in the controller 180.

At step 301 in Fig. 9, an initial mounting order O1 is applied, which may be any order. At step 302, distances from each of mounting points 173 to all of mounting points 173 present on the circuit board 2, for example, each distance from a first mounting point to each of a second, a third, ... and an n mounting points, each distance from the second mounting point to each of the third, a fourth, ... and the n mounting points, and the like are obtained and stored. Moreover, an initial mounting path P1 is obtained on the basis of the initial mounting order O1 under the arrangement of parts cassettes 103a obtained in the foregoing steps 100 and 200. At step 303, a path length of the initial mounting path P1 is obtained with the use of the above distances between mounting points 173, and the initial mounting path P1 and the path length of the initial mounting path P1 are substituted for a "mounting path P" and an "optimum mounting path length Lopt" respectively. At step 304, the initial mounting order O1 is substituted for a "mounting order O" and an "optimum mounting order Oopt". At step 305, the initial component cassettes arrangement ZO1 which is the arrangement of parts cassettes 103a obtained in steps 100 and 200 is substituted for a "component cassettes arrangement ZO" and an "optimum component cassettes arrangement ZOopt". At step 306, 0 is substituted for the "number of recombination times (a)" within the operation at step 307 to be described below.

At step 307, for optimizing the mounting order O through optimization of the mounting path P, the mounting order O is optimized with the utilization of the recombination method, thereby obtaining a new mounting order Onew and a new mounting path Pnew. As will be detailed below, the recombination method is such that two unit paths are selected from the mounting path, a new path is formed by changing starting points and end points of the selected unit paths, and the new path is adopted if the new path has a shorter path length than that of the path before the recombination. This recombination method will be discussed with reference to steps 320-330 shown in Figs. 10 and 11, and Figs. 12-14.

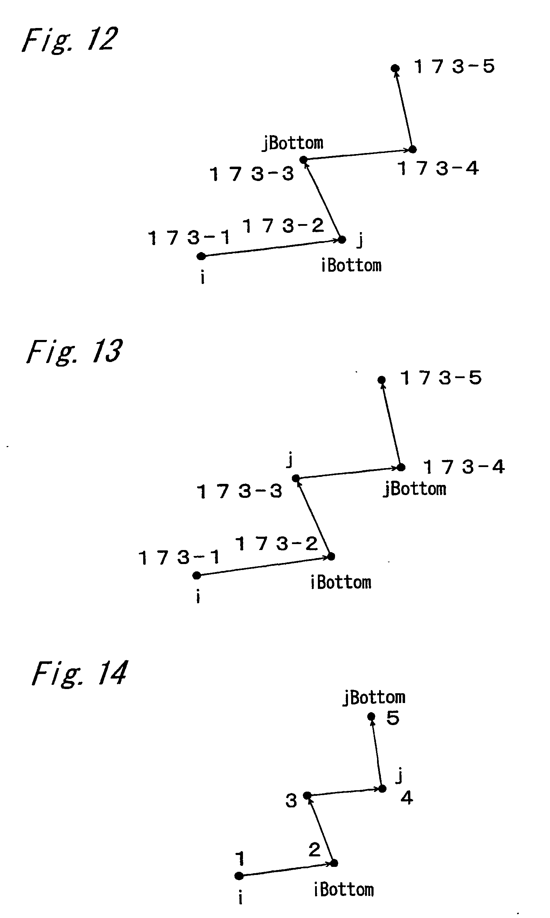

At steps 320 and 321, i is made a first mounting point, that is, i=1 is set and a mounting point j is made j=i+1 in the initial mounting order O1. A mounting point to which the component is mounted next to the mounting point i is a mounting point iBottom, and a mounting point to which the component is mounted next to the mounting point j is a mounting point jBottom. At step 322, a first unit path u1 for connecting the mounting points i and iBottom, and a second unit path u2 for connecting the mounting points j and jBottom are selected to be objects of recombination. In the following description, for example, the first unit path u1 is notated by u1 (i, iBottom) and the second unit path is notated by u2 (j, jBottom). The mounting order will be more specifically described with reference to Fig. 12. Supposed that there are five mounting points 173-1 to 173-5 and the initial mounting order is set to be an order from the mounting point 173-1 to the mounting point 173-5, for instance, the mounting point j becomes the mounting point 173-2 when the mounting point 173-1 is set as the mounting point i. Also the mounting point 173-2 corresponds to the mounting point iBottom and the mounting point 173-3 corresponds to the mounting point jbottom. Under the above condition, the first unit path u1 is expressed by the notation (173-1, 173-2) and the second unit path u2 is expressed by the notation (173-2, 173-3).

At step 323, a sum of lengths of the first unit path u1 (173-1, 173-2) and the second unit path u2 (173-2, 173-3) is obtained with reference to distance information between each mounting point 173 stored at step 302. The sum is stored into "Dorg".

At step 324, before the unit path u1 (i, iBottom) and the unit path u2 (j, jBottom) selected as objects of recombination are actually recombined, a unit path length after the recombination is obtained on the basis of distance information of mounting points 173 stored at step 302, and is substituted for "Dpara".

At step 325, "Dorg" value is compared with "Dpara" value. The two unit paths are actually subjected to recombination at step 326 only when "Dpara" value is smaller than "Dorg".

At step 326, a mounting path composed of a third unit path u3 (i, j) and a fourth unit path u4 (iBottom, jBottom) is formed by replacing the end points and the starting points of the above unit path u1 (i, iBottom) and unit path u2 (j, jBottom) respectively, so that the formed mounting path is reflected onto the mounting order.

In the example shown in Fig. 12, since the mounting point iBottom and the mounting point j are the same mounting point (173-2) and consequently "Dorg" value and "Dpara" value are equal, step 326 is not carried out and the process proceeds to step 327.

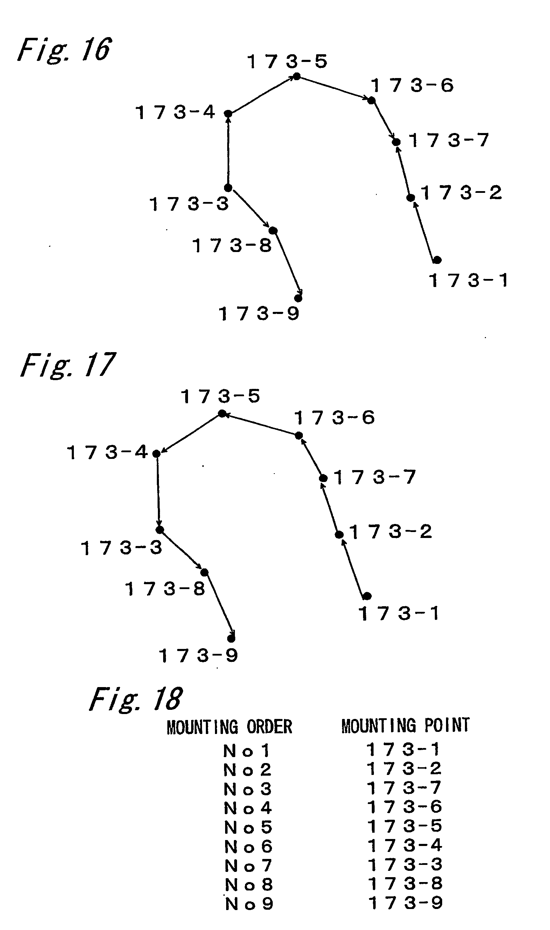

The operation of reflecting the mounting path to the mounting order at step 326 as above will be detailed. Supposed that mounting points 173-1 to 173-9 are first allotted from the mounting point 173-1 to the mounting point 173-9 corresponding to from a mounting order No. 1 to a mounting order No. 9, the mounting path traces a sequence from the mounting point 173-1 to the mounting point 173-9 as shown in Fig. 15. The mounting path is determined by this sequence. Then the mounting path is optimized by the recombination as described at steps 302-307. When the mounting path of the example shown in Fig. 15 is optimized, since paths (173-2, 173-7) and (173-3, 173-8) could shorten the path length more than the paths (173-2, 173-3) and (173-7, 173-8), the mounting path is hence changed to the paths (173-2, 173-7) and (173-3, 173-8).

However, even when the mounting path is changed as above, electronic components are mounted by the same mounting path as that of Fig. 15 unless the mounting order is changed. The mounting order is designated by incrementing program steps. Accordingly, at step 326, mounting points are switched correspondingly to the mounting path so that the optimized mounting path matches with the mounting order designated by the increment. The switching is carried out to continue the mounting order between the optimized two unit paths and a path present between the two paths. Namely, when the paths (173-2, 173-3) and (173-7, 173-8) are merely changed to the paths (173-2, 173-7) and (173-3, 173-8) in the above example, the mounting order in the paths (173-2, 173-7) and (173-3, 173-8) and the path from the mounting point 173-3 to the mounting point 173-7 cannot continue as in Fig. 16. That is, the mounting order diverges to both the mounting point 173-4 and the mounting 173-8 from the mounting point 173-3, and furthermore, the mounting order collides from both the mounting point 173-6 and the mounting point 173-2 at the mounting point 173-7.

For securing continuity of the mounting order, namely, for reflecting the optimized mounting path to the mounting order, mounting points corresponding to the mounting orders Nos. 3-7 are changed in the above example as shown in Fig. 17. Specifically, mounting points 173-3 to 173-7 corresponding to the mounting orders Nos. 3-7 are inverted to be mounting points 173-7 to 173-3 correspondingly to the mounting orders Nos. 3-7 as indicated in Fig. 18 before the optimization. Since the optimized mounting path is reflected to the mounting order in this manner at step 326, the mounting operation carried out from the mounting order No. 1 to the mounting order No. 9 will follow the optimized path of Fig. 17.

Step 327 is carried out in the case where the mounting point j is smaller than a value obtained by subtracting 1 from a total number of mounting points. When the mounting point j is larger than the value, the process moves on to step 328. After 1 is added to the mounting point j at step 327, the step returns to step 322. Concretely, the mounting point j changes from the mounting point 173-2 to the mounting point 173-3 and the mounting point jBottom becomes the mounting point 173-4 as shown in Fig. 13 when 1 is added to the mounting point j. Then, at step 322, unit paths u1 (173-1, 173-2) and u5 (173-3, 173-4) are selected as objects of recombination. At step 323, a sum of the unit paths u1 and u5 is obtained on the basis of the distance information. At step 324, by the recombination from paths (i, iBottom) and (j, jBottom) to paths (i, j) and (iBottom, jBottom) as above, a sum of a unit path u6 (173-1, 173-3) and a unit path u7 (173-2, 173-4) as paths after the recombination of the above unit paths u1 and u5 is obtained on the basis of the distance information. The steps 325 and 326 are carried out then. The recombination is executed only when the "Dpara" value is smaller, whereby a mounting path composed of the unit path u6 (173-1, 173-3) and unit path u7 (173-2, 173-4) is formed. Step 327 is subsequently carried out again.

At step 327, there is also a unit path obtained in the present example by adding 1 to the mounting point j other than the above unit path (173-3, 173-4), in which the mounting point j becomes the mounting point 173-4 and the mounting point jBottom becomes the mounting point 173-5 as shown in Fig. 14. However, since the total number of mounting points is 5 in the example and the mounting point jBottom comes not to exist if the mounting point j is made the mounting point 173-5, the mounting point j can be up to the mounting point 173-4 at step 327. Therefore, at step 322, unit paths to be objects of recombination are the above (173-1, 173-2) and (173-3, 173-4), and (173-1, 173-2) and (173-4, 173-5). Steps 322-326 are carried out also for the unit paths (173-1, 173-2) and (173-4, 173-5).

A path of a shorter mounting path length is thus obtained by changing the mounting point j and obtaining the path length of the path after the recombination at each time.

Step 327 moves to step 328 at a time point when the mounting point j exceeds the mounting point 173-4.

At step 327, the shorter mounting path is obtained by changing only the mounting point j without changing the mounting point i. In contrast, at step 328, the shorter mounting path is obtained by adding 1 to the mounting point i thereby changing the mounting point i as well and then returning to the step 321. More specifically, in the above explanation up to step 327, while the comparison is made sequentially in an order of between unit paths (173-1, 173-2) and (173-2, 173-3), between unit paths (173-1, 173-2) and (173-3, 173-4), between unit paths (173-1, 173-2) and (173-4, 173-5), when and since step 328 is executed, steps 322-327 are carried out also for each of between the unit paths (173-2, 173-3) and (173-3, 173-4) and between unit paths (173-2, 173-3) and (173-4, 173-5).

At step 328, since the mounting point j becomes the mounting point 173-5 and the mounting point jBottom comes not to exist when the mounting point i is made the mounting point 173-4, the mounting point i is up to the mounting point 173-3, i.e., a value reduced by 2 from the total number of mounting points. The step advances to step 329 when the mounting point i exceeds the mounting point 173-3.

A shorter mounting path is obtained in the above manner at step 328 by changing both the mounting point i and the mounting point j.

At step 329, a total mounting path length L is obtained for the path after the recombination obtained by the operations up to step 328. The total mounting path length L is compared with the "optimum mounting path length (Lopt) " at step 330. As a result of the comparison, the process is terminated when both values agree. The step returns to step 320 by adding 1 to the "number of recombination times (a)" when the values disagree, so that the above-described recombination operation is carried out again. The reason for carrying out the same operation is because it is unclear whether or not the path is shortest although the path is naturally shortened by the execution of the operations up to step 330. In the case where the total mounting path length L becomes slightly shorter than the optimum mounting path length Lopt which corresponds to the total mounting path length in the previous operation at every recombination time, the process is terminated when the "number of recombination times (a)" reaches a set value to save a processing time.

The operation of step 300 completes by the operations from the above step 320 to step 329.

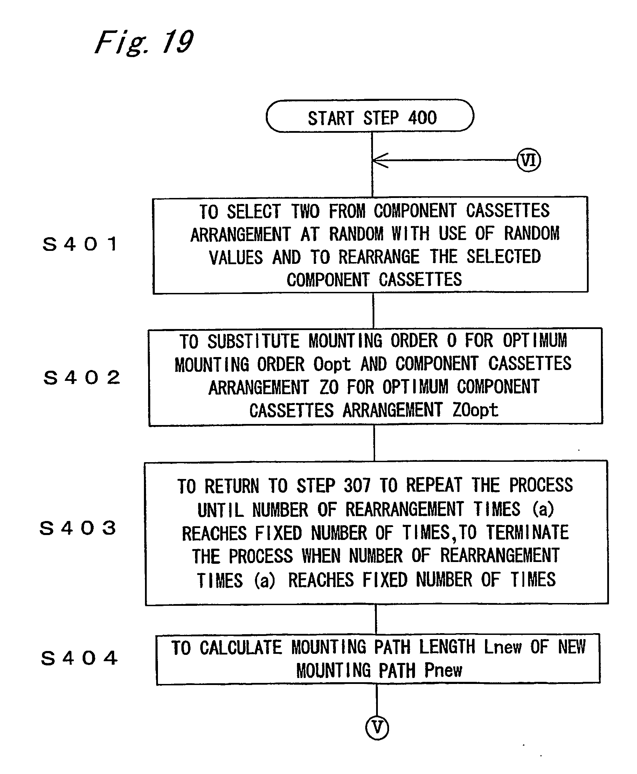

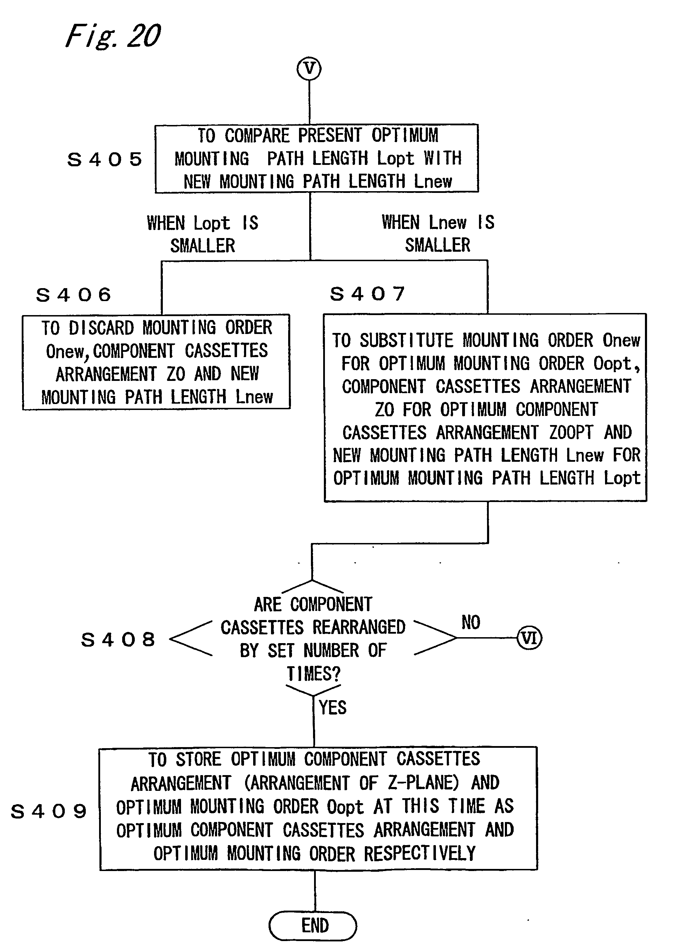

Step 400 will be described with reference to Figs. 19 and 20 which are halves of a flow chart divided because of a sheet size and continue at marks V and VI.

Step 400 is an operation for adding correction to obtain a better component mounting order, in which arbitrary two of parts cassettes 103a arranged in steps 100 and 200 are rearranged, and the mounting path, the mounting order and the mounting path length are obtained again for the rearranged parts cassettes. This will be depicted in detail below.

At step 401, arbitrary two parts cassettes 103a are selected with the use of random numbers in the arrangement of parts cassettes 103a obtained by step 200. The two parts cassettes are replaced in the arrangement. At next step 402, the mounting order O obtained by the foregoing step 300 is adopted as the "optimum mounting order Oopt", and the component cassettes arrangement ZO by the component cassettes arrangement changed at step 401 is substituted for the "optimum component cassettes arrangement ZOopt". At step 403, step 307 is executed for the changed arrangement to optimize the mounting order by the recombination method. The recombination is carried out until the number of recombination times (a) reaches a set value. At step 404, a new mounting path length Lnew of a new mounting path Pnew obtained at step 403 is obtained.

At step 405, the present optimum mounting path length Lopt is compared with the new mounting path length Lnew. When the optimum mounting path length Lopt is shorter as a result of the comparison, the new mounting path length Lnew, the changed component cassettes arrangement ZO and a mounting order Onew based on the changed component cassettes arrangement are discarded at step 406. On the other hand, when the new mounting path length Lnew is shorter, the mounting order Onew is substituted for the "optimum mounting order Oopt", the component cassettes arrangement ZO is substituted for the "optimum component cassettes arrangement ZOopt" and the new mounting path length Lnew is substituted for the "optimum mounting path length Lopt" at step 407.

At step 408, it is determined whether or not the rearrangement of arbitrary two parts cassettes 103a at step 401 is carried out by the set number of times. In the case where the number is smaller than the set number of times, the step returns to step 401. When the rearrangement is carried out by the set number of times, the step goes to step 409, where the optimum component cassettes arrangement and the optimum mounting order Oopt at this time are stored as the optimum component cassettes arrangement and the optimum mounting order respectively, thereby terminating step 400.

As described hereinabove, according to the present embodiment, the arrangement of parts cassettes 103a is obtained with the relation to the mounting positions on the circuit board 2 taken into account in steps 100 and 200. Therefore, the mounting time can be shortened in comparison with the conventional art. Moreover, the mounting path to the mounting positions is optimized by executing step 300 and further step 400 under the obtained arrangement of parts cassettes 103a, so that the mounting order can be optimized. The mounting time can accordingly be shortened furthermore as compared with the conventional art.

In Fig. 25, a movement amount of each part when the components are mounted by the component mounting order optimization method according to the above-described embodiment is compared with a movement amount by mounting methods A and B other than the present embodiment. An "XY movement distance" shown in Fig. 25 is the mounting path length on the circuit board expressed by the unit of mm, and a "three-dimensional movement distance" is a total movement distance expressed by the unit of mm of the nozzle 105b required for the mounting operation when each Z-number of the parts cassettes 103 arranged by a pitch of 22mm is converted to the length. A "total Z shift" is a movement distance of parts cassettes 103a counted in units of Z-numbers. For instance, supposed that the parts cassettes 103a are disposed at Z-numbers 1, 3 and 5 and electronic components are taken out from the parts cassettes 103a sequentially from Z-numbers 1→3 →5, the "total Z shift" becomes 4 (=2+2). As is apparent from Fig. 25, although the "total Z shift" is smaller in the mounting method A than in the present embodiment in some cases, the "three-dimensional movement distance" showing the total movement distance is shorter in the present embodiment. Therefore, the present embodiment can shorten the mounting path as a whole in comparison with the conventional art, enabling shortening the mounting time in comparison with the conventional art.

After the component mounting order optimized by the above-discussed component mounting order optimization method is obtained, the controller 180 controls driving of the drive unit 104a of the supply table 104 according to the component mounting order to locate a desired parts cassette 103a to the component holding position 171, and also controls driving of the drive units 109a and 109b of the orthogonal table 109 to position a desired mounting point 173 of the circuit board 2 to the component mounting position 172, thereby carrying out the component mounting operation to the circuit board 2. At this time, after the operation in step 400 ends in the case where the operations up to step 400 are carried out, or after the operation in step 300 ends when the operations up to step 300 are carried out without carrying out step 400, the worker arranges each parts cassette 103a onto the supply table 104 in accordance with the optimized arrangement of parts cassettes 103a which is obtained in step 400 or 300. After the parts cassettes are arranged, the mounting operation for electronic components to the circuit board 2 is carried out by the component mounting apparatus 101 in accordance with the optimized component mounting order.

In the case where the operations up to step 300 are carried out excluding step 400, after steps 100 and 200 end, the worker may arrange each parts cassette 103a onto the supply table 104 in accordance with the optimized arrangement of parts cassettes 103a without waiting for the end of step 300.

The component shift device 105 of the so-called rotary type is adopted as an example of a component shift device in the above embodiment. But the component shift device installed in the component mounting apparatus 101 is not limited to the rotary type, the component shift device such as a component insertion device which transfers the components from the parts cassettes 103a to the circuit board 2 without shifting the components along a circular path can be installed.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

**Claims**

1. A component mounting order optimization method executed before carrying out a component mounting operation in which a component is held from one component supply part (103a) disposed at a component holding position (171) among a plurality of component supply parts (103a) arranged in parallel and arranged movably for supplying components, is transferred to a component mounting position (172), and is mounted to a mounting point (173) on a circuit board (2) disposed at the component mounting position by moving in X-axis and Y-axis directions, the method comprising:

   representing the mounting point (173) in a three dimensional space which is given that a Z-number showing a location of each component supply part (103a) is expressed by a Z-axis and a plane of the circuit board (2) is expressed by the X and Y-axes; and
   determining an arrangement of the component supply parts (103a) and a component mounting order on the circuit board (2) so that a component mounting path connecting the mounting points (173) in the three dimensional space becomes the shortest.

2. The component mounting order optimization method according to Claim 1, wherein the determining operation has:

   optimizing the arrangement of the component supply parts (103a) with position information of the mounting points (173) taken into account; and then
   optimizing the component mounting path in the three dimensional space so that the mounting path becomes the shortest under the optimized arrangement of the component supply parts (103a).

3. The component mounting order optimization method according to Claim 2, further comprising:

   after the optimization of the component mounting path, rearranging the component supply parts, (103a); optimizing the component mounting path again under the rearrangement of the component supply parts (103a); and selecting a component mounting path having a shorter mounting path length through comparison between before and after the rearrangement of the component supply parts (103a).

4. The component mounting order optimization method according Claim 2, wherein the optimization of the arrangement of the component supply parts (103a) is carried out by temporarily arranging the component supply parts (103a) and correcting the temporary arrangement before optimizing the component mounting path.

5. The component mounting order optimization method according to Claim 4, wherein the temporary arrangement in optimizing the arrangement of the component supply parts (103a) is executed by obtaining a product of variances ($\sigma$1, $\sigma$2) for each of X and Y-coordinate values and Z-values showing locations of the component supply parts (103a) in terms of the mounting points (173) of the circuit board (2) while the Z-value is changed, and then obtaining the arrangement of the component supply parts (103a) which makes the variance product ($\sigma$1, $\sigma$2) smaller.

6. The component mounting order optimization method according to Claim 5, wherein, the arrangement which makes the variance product ($\sigma$1, $\sigma$2) smaller is obtained by executing:

   a first process of obtaining a first variance product for a first arrangement of the component supply parts (103a);
   a second process of obtaining a second variance product for a second arrangement different from the first arrangement; and
   a third process of comparing the first variance product and the second variance product with each other and setting the smaller one as a new first variance product,
   thereby obtaining a much smaller new first variance product by repeating the second process and the third process subsequently.

7. The component mounting order optimization method according to Claim 4, wherein, for correcting the temporary arrangement in optimizing the arrangement of the component supply parts (103a), after the component supply parts (103a) are temporarily arranged by obtaining the smaller variance product ($\sigma$1, $\sigma$2), the location of a second component supply part (103a-2) is changed on a basis of a distance between a reference mounting position (178) on the circuit board (2) where the component supplied from a first component supply part (103a-1) adjacent to the component holding position (171) is to be mounted and an object mounting position (179) on the circuit board (2) where the component supplied from the second component supply part (103a-2) other than the first component supply part (103a-1) is to be mounted, thereby further optimizing the arrangement of the component supply parts (103a).

8. The component mounting order optimization method according Claim 7, wherein the changing of the location of the second component supply part (103a-2) comprises:

   obtaining each of the distances while the second component supply part (103a-2) is sequentially changed; and
   arranging the second component supply part (103a-2) which makes the distance shortest adjacent to the first component supply part (103a-1).

9. The component mounting order optimization method according to Claim 2, wherein the component mounting path is optimized by selecting two mounting paths for connecting two mounting points (173) among mounting paths, recombining the two mounting paths, and selecting the path having a shorter mounting path length through comparison between-before and after the recombination, thereby executing the optimization.

10. A component mounting order optimization program for making a computer execute a component mounting order optimization method in a component mounting operation in which a component is held from one component supply part (103a) disposed at a component holding position (171) among a plurality of component supply parts (103a) arranged in parallel and movable for supplying components, is transferred to a component mounting position (172), and is mounted to a mounting point (173) on a circuit board (2) disposed at the component mounting position (172) by moving in X-axis and Y-axis directions, the program comprising:

    a procedure of representing the mounting point (173) in a three dimensional space which is given that a Z-number showing a location of each component supply part (103a) is expressed by a Z-axis and a plane of the circuit board (2) is expressed by the X and Y-axes; and
    a procedure of determining an arrangement of the component supply parts (103a) and a component mounting order on the circuit board (2) so that a component mounting path connecting the mounting points (173) in the three dimensional space becomes the shortest.

11. The component mounting order optimization program according to Claim 10, wherein the procedure of determination has:

a procedure of optimizing the arrangement of the component supply parts (103a) with position information of the mounting points (173) taken into account; and then

a procedure of optimizing the component mounting path in the three dimensional space so that the mounting path becomes the shortest under the optimized arrangement of the component supply parts (103a).

12. The component mounting order optimization program according to Claim 11, further comprising:

after the optimization of the component mounting path, a procedure of rearranging the component supply parts (103a); a procedure of optimizing the component mounting path again under the rearrangement of the component supply parts (103a); and a procedure of selecting a component mounting path having a shorter mounting path length through comparison between before and after the rearrangement of the component supply parts (103a).

13. The component mounting order optimization program according to Claim 11, wherein the optimizing procedure for the arrangement of the component supply parts (103a) includes a procedure of temporarily arranging the component supply parts (103a) and a procedure of correcting the temporary arrangement before the optimizing procedure for the component mounting path.

14. The component mounting order optimization program according to Claim 13, wherein the temporary arrangement procedure in the optimizing procedure for the arrangement of the component supply parts (103a) includes a procedure of obtaining a product of variances ($\sigma 1$, $\sigma 2$) of each of X and Y-coordinate values and Z-values showing locations of the component supply parts (103a) white the Z-value is changed in terms of the mounting points (173) of the circuit board (2), and a procedure of obtaining the arrangement of the component supply parts (103a) which makes the variance product ($\sigma 1$, $\sigma 2$) smaller.

15. The component mounting order optimization program according to Claim 14, wherein the arrangement procedure of making the variance product ($\sigma 1$, $\sigma 2$) smaller includes:

a first procedure of obtaining a first variance product for a first arrangement of the component supply parts (103a);

a second procedure of obtaining a second variance product for a second arrangement different from the first arrangement;

a third procedure of comparing the first variance product and the second variance product with each other and setting the smaller one as a new first variance product; and

a procedure of obtaining a much smaller new first variance product by repeating the second procedure and the third procedure subsequently.

16. The component mounting order optimization program according to Claim 13, wherein the correcting procedure for the temporary arrangement in optimizing the arrangement of the component supply parts (103a) includes, after the component supply parts (103a) are temporarily arranged by obtaining the smaller variance product, a procedure of changing the location of a second component supply part (103a-2) on a basis of a distance between a reference mounting position (178) on the circuit board (2) where the component supplied from a first component supply part (103a-1) adjacent to the component holding position is to be mounted and an object mounting position (179) on the circuit board (2) where the component supplied from the second component supply part (103a-2) other than the first component supply part (103a-1) is to be mounted, thereby further optimizing the arrangement of the component supply parts (103a).

17. The component mounting order optimization program according to Claim 16, wherein the procedure of changing the location of the second component supply part (103a-2) includes a procedure of obtaining each of the distances while the second component supply (103a-2) part is sequentially changed and arranging the second component supply part (103a-2) which makes the distance shortest to be adjacent to the first component supply part (103a-1).

18. The component mounting order optimization program according to Claim 11. wherein the optimizing procedure for the component mounting path includes a procedure of selecting two among mounting paths for connecting two mounting points (173), recombining the two mounting paths, and selecting the path having a shorter mounting path length through comparison between before and after the recombination, thereby executing the optimization.

19. A computer readable recording medium with a program according to claim 10 stored thereon.

20. The computer readable recording medium according to Claim 19, wherein the procedure of determination has:

a procedure of optimizing the arrangement of the component supply parts (103a) with position information of the mounting points (173) taken into account; and then

a procedure of optimizing the component mounting path in the three dimensional space so that the mounting path becomes the shortest under the optimized arrangement of the component supply parts (103a).

**21.** The computer readable recording medium according to Claim 20, further comprising:

after the optimization of the component mounting path, a procedure of rearranging the component supply parts (103a);

a procedure of optimizing the component mounting path again under the rearrangement of the component supply parts (103a); and a procedure of selecting a component mounting path having a shorter mounting path length through comparison between before and after the rearrangement of the component supply parts (103a).

**22.** The recording medium according to Claim 20, wherein the optimizing procedure for the arrangement of the component supply parts (103a) includes a procedure of temporarily arranging the component supply parts (103a) and a procedure of correcting the temporary arrangement before the optimizing procedure for the component mounting path.

**23.** The recording medium according to Claim 22, wherein the temporary arrangement procedure in the optimizing procedure for the arrangement of the component supply parts (103a) includes a procedure of obtaining a product of variances ($\sigma$1, $\sigma$2) of each of X and Y-coordinate values and Z-values showing locations of the component supply parts (103a) while the Z-value is changed in terms of the mounting points (173) of the circuit board (2), and a procedure of obtaining the arrangement of the component supply parts (103a) which makes the variance product ($\sigma$1, $\sigma$2) smaller.

**24.** The recording medium according to Claim 23, wherein the arrangement procedure for making the variance product ($\sigma$1, $\sigma$2) smaller includes:

a first procedure of obtaining a first variance product for a first arrangement of the component supply parts (103a);

a second procedure of obtaining a second variance product for a second arrangement different from the first arrangement;

a third procedure of comparing the first variance product and the second variance product with each other and setting the smaller one as a new first variance product; and

a procedure of obtaining a much smaller new first variance product by repeating the second procedure and the third procedure subsequently.

**25.** The recording medium according to Claim 22, wherein the correcting procedure for the terriporary arrangement in optimizing the arrangement of the component supply parts (103a) includes, after the component supply parts (103a) are temporarily arranged by obtaining the smaller variance product, a procedure of changing the location of a second component supply part (103a-2) on a basis of a distance between a reference mounting position (178) on the circuit board (2) where the component supplied from a first component supply part (103a-1) adjacent to the component holding position is to be mounted and an object mounting position (179) on the circuit board (2) where the component supplied from the second component supply part (103a-2) other than the first component supply part (103a-1) is to be mounted, thereby further optimizing the arrangement of the component supply parts (103a).

**26.** The recording medium according to Claim 25, wherein the procedure of changing the location of the second component supply part (1 03a-2) includes a procedure of obtaining each of the distances while the second component supply part (103a-2) is sequentially changed, and arranging the second component supply part (103a-2) which makes the distance shortest to be adjacent to the first component supply part (103a-1).

**27.** The recording medium according to Claim 20, wherein the optimizing procedure for the component mounting path includes a procedure of selecting two among mounting paths for connecting two mounting points (173), recombining the two mounting paths, and selecting the path having a shorter mounting path length through comparison between before and after the recombination, thereby executing the optimization.

**28.** A component mounting apparatus comprising

a component supply unit (103) having a plurality of supply parts (103a) arranged in parallel for supplying components, for supplying components from one of the supply parts positioned to a component holding position (171);

a component shift device (105) having a component holder (105b), for transferring the component holder between the component holding position (171) and a component mounting position (172), holding components (175) supplied from the supply parts by the component holders and mounting the components to mounting points (173) on a circuit board (2) at the component mounting position;

an orthogonal table (109) for holding the circuit board (2) and moving the circuit board (2) in X and Y-axes directions, thereby locating the mounting points (173) to the component mounting position; and

a controller (180) for optimizing a mounting operation of the components to the circuit board (2) from the supply parts, which includes an arrangement optimizing part (181) for representing the mounting point (173) in a three dimensional space which is given that a Z-number showing a location of each component supply part (103a) is expressed by a Z-axis and a plane of the circuit board (2) is expressed by the X and Y-axes, and a mounting path optimizing part (182) for determining an arrangement of the component supply parts (103a) and a component mounting order on the circuit board (2) so that a component mounting path connecting the mounting points (173) in the three dimensional space becomes the shortest.

29. The component mounting apparatus according to Claim 28, wherein the arrangement optimizing part carries out optimization of the arrangement of the component supply parts (103a) with position information of the mounting points (173) taken into account, and the mounting path optimizing part carries out optimization of the component mounting path in the three dimensional space so that the mounting path becomes the shortest under the optimized arrangement of the component supply parts (103a).

30. The component mounting apparatus according to Claim 29, wherein the mounting path optimizing part further carries out rearrangement of the component supply parts (103a) after the optimization of the component mounting path, optimization of the component mounting path again under the rearrangement of the component supply parts (103a), and selection of a component mounting path having a shorter mounting path length through comparison between before and after the rearrangement of the component supply parts (103a).

31. The component mounting apparatus according to Claim 28, wherein the arrangement optimizing part obtains a product of three variances of each of X and Y-coordinate values and Z-values showing locations of the supply parts while the Z-value is changed in terms of the mounting points (173) on the circuit board (2), and obtains the arrangement of the component supply parts (103a) which makes the variance product ($\sigma1$, $\sigma2$) smaller.

32. The component mounting apparatus according to Claim 31, wherein the arrangement optimizing part obtains the arrangement which makes the variance product ($\sigma1$, $\sigma2$) smaller by obtaining a first variance product for a first arrangement of the supply parts, obtaining a second variance product for a second arrangement different from the first arrangement, comparing the first variance product and the second variance product with each other to set the smaller one as a new first variance product, and obtaining a much smatter variance product as a new first variance product by repeating the comparison.

33. The component mounting apparatus according to Claim 31, wherein the arrangement optimizing part further optimizes the arrangement of the supply parts, after optimizing the arrangement of the supply parts by obtaining the smaller variance product, caused by changing a location of a second supply part (103a-2) on a basis of a distance between a reference mounting position (178) where the component supplied from a first supply part (103a-1) adjacent to the component holding position is to be mounted and an object mounting position (179) where the component supplied from the second supply part (103a-2) other than the first supply part (103a-1) is to be mounted.

34. The component mounting apparatus according to Claim 33, wherein for changing the location of the second supply part (103a-2), the distance is obtained while the second supply part (103a-2) is sequentially changed and the second supply part (103a-2) which makes the distance shortest is arranged adjacent to the first supply part (103a-1).

35. The component mounting apparatus according to Claim 28, wherein the mounting path optimizing part optimizes by selecting two among mounting paths for connecting two mounting points (173), recombining the two mounting paths, and selecting the path having a shorter mounting path length through comparison between before and after the recombination.

36. The component mounting apparatus according to Claim 35, wherein the mounting path optimizing part changes a mounting order of mounting points (173) which constitute a new mounting path after the recombination of mounting paths, in accordance with the new mounting path.

**Patentansprüche**

1. Verfahren zur Optimierung der Bestückungsfolge, welches vor der Durchführung eines Bauteilbestückungsvorganges ausgeführt wird, bei dem ein Bauteil aus einem Bauteilzuführabschnitt (103a), der an einer Bauteilaufnahmeposition (171) angeordnet ist, wobei der Bauteilzuführabschnitt einer von mehreren Bauteilzuführabschnitten (103a) ist, die parallel zu einander und für die Zuführung von Bauteilen bewegbar angeordnet sind, aufgenommen wird, zu einer Bauteilbestückungsposition (172) verfahren wird und an einem Bestückungspunkt (173) auf einer Schaltungsplatine (2), die in der Bauteilbestückungsposition durch Bewegen in die X-Achsenrichtung und die Y-Achsenrichtung angeordnet wurde, montiert wird, wobei das Verfahren die Schritte enthält:

   Darstellen des Bestückungspunktes (173) in einem dreidimensionalen Raum, welcher **dadurch** gegeben ist, dass eine Z-Zahl, welche den Ort jedes Bauteilzuführabschnittes (103a) wiedergibt, durch die Z-Achse sowie die Ebene der Schaltungsplatine (2) durch die X- und die Y-Achse ausgedrückt werden, und
   Bestimmen einer Anordnung der Bauteilzuführabschnitte (103a) und einer Bauteilbestückungsfolge auf der Schaltungsplatine (2) in der Weise, dass ein Bauteilbestückungsweg, welcher die Bestückungspunkte (173) in dem dreidimensionalen Raum verbindet, am kürzesten wird.

2. Verfahren zur Optimierung der Bestückungsfolge nach Anspruch 1, bei dem der Bestimmungsvorgang die folgenden Schritte enthält:

   Optimierung der Anordnung der Bauteilzuführabschnitte (103a) durch Berücksichtigung von Positionsinformationen der Bestückungspunkte (173) und anschließend
   Optimierung des Bauteilbestückungsweges in dem dreidimensionalen Raum in der Weise, dass der Bestückungsweg bei der optimierten Anordnung der Bauteilzuführabschnitte (103a) am kürzesten wird.

3. Verfahren zur Optimierung der Bestückungsfolge nach Anspruch 2, weiterhin enthaltend:

   nach der Optimierung des Bauteilbestückungsweges Neuanordnung der Bauteilzuführabschnitte (103a), nochmalige Optimierung des Bauteilbestückungsweges unter Berücksichtigung der Neuanordnung der Bauteilzuführabschnitte (103a) und Auswählen eines Bauteilbestückungsweges mit einer kürzeren Bestückungsweglänge durch Vergleichen des Zustands vor mit dem Zustand nach der Neuanordnung der Bauteilzuführabschnitte (103a).

4. Verfahren zur Optimierung der Bestückungsfolge nach Anspruch 2, bei dem die Optimierung der Anordnung der Bauteilzuführabschnitte (103a) durch temporäres Anordnen der Bauteilzuführabschnitte (103a) und Korrigieren der temporären Anordnung vor der Optimierung des Bauteilzuführweges ausgeführt wird.

5. Verfahren zur Optimierung der Bestückungsfolge nach Anspruch 4, bei dem die temporäre Anordnung bei der Optimierung der Anordnung der Bauteilzuführabschnitte (103a) **dadurch** ausgeführt wird, dass ein Produkt der Varianzen ($\sigma1$, $\sigma2$) für jeden der X- und Y-Koordinatenwerte sowie Z-Werte gebildet wird, die die Orte der Bauteilzuführabschnitte (103a) in Form von Bestückungspunkten (173) der Schaltungsplatine (2) wiedergeben, während der Z-Wert geändert wird, und dass anschließend die Anordnung der Bauteilzuführabschnitte (103a) erhalten wird, welche das Varianzprodukt ($\sigma1$, $\sigma2$) kleiner werden lässt.

6. Verfahren zur Optimierung der Bestückungsfolge nach Anspruch 5, bei dem die Anordnung, welche das Varianzprodukt ($\sigma1$, $\sigma2$) kleiner werden lässt, erhalten wird durch Ausführung:

   eines ersten Vorgangs des Bildens eines ersten Varianzproduktes für eine erste Anordnung der Bauteilzuführabschnitte (103a),
   eines zweiten Vorgangs des Bildens eines zweiten Varianzproduktes für eine zweite Anordnung, welche von der ersten Anordnung verschieden ist; und
   eines dritten Vorgangs des Vergleichens des ersten Varianzproduktes und des zweiten Varianzproduktes miteinander und des Festlegens des kleineren Varianzproduktes als neues erstes Varianzprodukt,
   wodurch ein neues, viel kleineres erstes Varianzprodukt durch aufeinanderfolgendes Wiederholen des zweiten und des dritten Vorganges erhalten wird.

7. Verfahren zur Optimierung der Bestückungsfolge nach Anspruch 4, bei dem zum Korrigieren der temporären Anordnung bei der Optimierung der Anordnung der Bauteilzuführabschnitte (103a) der Ort eines zweiten Bauteilzuführabschnittes (103a-2) geändert wird auf Basis eines Abstandes zwischen einer Referenzbestückungsposition (178) auf der Schaltungsplatine (2), in der das Bauteil, welches von einem ersten Bauteilzuführabschnitt (103a-1) benachbart der Bauteilaufnahmeposition (171) zugeführt worden ist, zu montieren ist, und einer Zielbestückungsposition (179) auf der Schaltungsplatine (2), in der das Bauteil, welches von dem zweiten Bauteilzuführabschnitt (103a-2) zugeführt worden ist, bei dem es sich um einen anderen als den ersten Bauteilzuführabschnitt (103a-1) handelt, zu montieren ist, nachdem die Bauteilzuführabschnitte (103 a) temporär durch Bestimmen des kleineren Varianzproduktes ($\sigma1$, $\sigma2$) angeordnet wurden, wodurch die Anordnung der Bauteilzuführabschnitte (103a) weiter optimiert wird.

8. Verfahren zur Optimierung der Bestückungsfolge nach Anspruch 7, bei dem die Änderung des Ortes des zweiten Bauteilzuführabschnittes (103a-2) die folgenden Schritte enthält:

   Bestimmen jedes der Abstände während der zweite Bauteilzuführabschnitt (103a-2) aufeinanderfolgend geändert wird, und

   Anordnen des zweiten Bauteilabschnittes (103a-2), der den Abstand am kürzesten werden lässt, neben dem ersten Bauteilzuführabschnitt (103a-1).

9. Verfahren zur Optimierung der Bestückungsfolge nach Anspruch 2, bei dem der Bauteilbestückungsweg optimiert wird durch Auswählen zweier Bestückungswege unter den Bestückungswegen zur Verbindung zweier Bestückungspunkte (173), Neukombinierung der beiden Bestückungswege und Auswählen des Weges, der eine kürzere Bestückungsweglänge aufweist, mittels Vergleich vor und nach der Neukombinierung, wodurch die Optimierung ausgeführt wird.

10. Programm zur Optimierung der Bestückungsfolge, um einen Computer zu veranlassen, ein Verfahren zur Optimierung der Bauteilbestückungsfolge bei einem Bauteilbestückungsvorgang auszuführen, bei dem ein Bauteil aus einem von mehreren an einer Bauteilaufnahmeposition (171) angeordneten Bauteilzuführabschnitten (103a) aufgenommen wird, wobei die Bauteilzuführabschnitte (103a) parallel zueinander und zum Zuführen der Bauteile bewegbar angeordnet sind, bei dem das Bauteil zu einer Bauteilbestückungsposition (172) verfahren wird und bei dem das Bauteil an einem Bestückungspunkt (173) auf einer Schaltungsplatine (2) montiert wird, die durch Bewegen in die X-Achsenrichtung und Y-Achsenrichtung in die Bauteilbestückungsposition (172) gebracht worden ist, wobei das Programm enthält:

   ein Verfahren zum Darstellen des Bestückungspunktes (173) in einem dreidimensionalen Raum, der **dadurch** gegeben ist, dass eine Z-Zahl, welche den Ort jedes Bauteilzuführabschnittes (103a) wiedergibt, durch die Z-Achse sowie die Ebene der Schaltungsplatine (2) durch die X- und Y-Achse ausgedrückt werden, und
   ein Verfahren zum Bestimmen einer Anordnung der Bauteilzuführabschnitte (103a) sowie einer Bauteilbestückungsfolge auf der Schaltungsplatine (2) in der Weise, dass ein Bauteilbestückungsweg, welcher die Bestückungspunkte (173) in dem dreidimensionalen Raum verbindet, am kürzesten wird.

11. Programm zur Optimierung der Bauteilbestückungsfolge nach Anspruch 10, bei dem das Bestimmungsverfahren enthält:

   ein Verfahren zur Optimierung der Anordnung der Bauteilzuführabschnitte (103a) durch Berücksichtigung von Positionsinformationen der Bestückungspunkte (173) und anschließend
   ein Verfahren der Optimierung des Bauteilbestückungsweges in dem dreidimensionalen Raum in der Weise, dass der Bestückungsweg bei der optimierten Anordnung der Bauteilzuführabschnitte (103a) am kürzesten wird.

12. Programm zur Optimierung der Bauteilbestückungsfolge nach Anspruch 11, weiterhin enthaltend:

   nach der Optimierung des Bauteilbestückungsweges ein Verfahren der Neuanordnung der Bauteilzuführabschnitte (103a), ein Verfahren der nochmaligen Optimierung des Bauteilbestückungsweges unter Berücksichtigung der Neuanordnung der Bauteilzuführabschnitte (103a) und ein Verfahren zum Auswählen eines Bauteilbestückungsweges, der eine kürzere Bestückungsweglänge aufweist, durch Vergleich zwischen der Situation vor und der Situation nach der Neuanordnung der Bauteilzuführabschnitte (1 03a).

13. Programm zur Optimierung der Bauteilbestückungsfolge nach Anspruch 11, bei dem das Optimierungsverfahren für die Anordnung der Bauteilzuführabschnitte (103a) ein Verfahren der temporären Anordnung der Bauteilzuführabschnitte (103a) sowie ein Verfahren zum Korrigieren der temporären Anordnung vor dem Optimierungsverfahren für den Bauteilbestückungsweg enthält.

14. Programm zur Optimierung der Bauteilbestückungsfolge nach Anspruch 13, bei dem das Verfahren zur temporären Anordnung in dem Optimierungsverfahren für die Anordnung der Bauteilzuführabschnitte (103a) ein Verfahren zum Bestimmen eines Produktes der Varianzen ($\sigma1$, $\sigma2$) jedes der X- und Y-Koordinatenwerte sowie der Z-Werte, die die Orte der Bauteilzuführabschnitte (103a) in Form von Bestückungspunkten (173) der Schaltungsplatine (2) wiedergeben, während der Z-Wert geändert wird, und ein Verfahren zum Bestimmen der Anordnung der Bauteilzuführabschnitte (103 a), welche das Varianzprodukt ($\sigma1$, $\sigma2$) kleiner werden lässt, enthält.

15. Programm zur Optimierung der Bauteilbestückungsfolge nach Anspruch 14, bei dem das Anordnungsverfahren zum Verkleinern des Varianzproduktes ($\sigma1$, $\sigma2$) enthält:

einen ersten Vorgang zum Bilden eines ersten Varianzproduktes für eine erste Anordnung der Bauteilzuführabschnitte (103a),
einen zweiten Vorgang zum Bilden eines zweiten Varianzproduktes für eine zweite Anordnung, die von der ersten Anordnung verschieden ist,
einen dritten Vorgang zum Vergleichen des ersten Varianzproduktes und des zweiten Varianzproduktes miteinander sowie zum Festlegen des kleineren Varianzproduktes als neues erstes Varianzprodukt, und
ein Verfahren zum Bilden eines neuen, viel kleineren ersten Varianzproduktes durch aufeinanderfolgendes Wiederholen des zweiten und des dritten Vorgangs.

16. Programm zur Optimierung der Bauteilbestückungsfolge nach Anspruch 13, bei dem das Korrekturverfahren für die temporäre Anordnung bei der Optimierung der Anordnung der Bauteilzuführabschnitte (103a) ein Verfahren enthält zum Ändern des Ortes eines zweiten Bauteilzuführabschnittes (103a-2) auf der Basis des Abstandes zwischen einer Referenzbestückungsposition (178) auf der Schaltungsplatine (2) enthält, in der das Bauteil, welches von einem ersten Bauteilzuführabschnitt (103a-1) benachbart zu der Bauteilaufnahmeposition zugeführt wird, zu montieren ist, und einer Zielbestückungsposition (179) auf der Schaltungsplatine (2), in der das Bauteil, welches von dem zweiten Bauteilzuführabschnitt (103a-2) zugeführt worden ist, bei dem es sich um einen anderen als den ersten Bauteilzuführabschnitt (103a-1) handelt, zu montieren ist, nachdem die Bauteilzuführabschnitte (103a) durch Bestimmen des kleineren Varianzproduktes temporär angeordnet wurden, wodurch die Anordnung der Bauteilzuführabschnitte (103a) weiter optimiert wird.

17. Programm zur Optimierung der Bauteilbestückungsfolge nach Anspruch 16, bei dem das Verfahren zum Ändern des Ortes des zweiten Bauteilzuführabschnittes (103a-2) ein Verfahren zum Bestimmen jedes der Abstände, während der zweite Bauteilzuführabschnitt (103a-2) aufeinanderfolgend geändert wird, und ein Verfahren zum Anordnen des zweiten Bauteilzuführabschnittes (103a-2), bei dem der Abstand am kürzesten ist, neben dem ersten Bauteilzuführabschnitt (103a-1) enthält.

18. Programm zur Optimierung der Bauteilbestückungsfolge nach Anspruch 11, bei dem das Optimierungsverfahren für den Bauteilbestückungsweg enthält:

ein Verfahren des Auswählens zweier Bestückungswege zum Verbinden zweier Bestückungspunkte (173) unter den Bestückungswegen, ein Verfahren der Neukombinierung der beiden Bestückungswege und ein Verfahren des Auswählens des Weges, der eine kürzere Bestückungsweglänge aufweist, durch Vergleich zwischen der Situation vor und nach der Neukombinierung, wodurch die Optimierung ausgeführt wird.

19. Computerlesbares Aufzeichnungsmedium mit einem darauf gespeicherten Programm nach Anspruch 10.

20. Computerlesbares Aufzeichnungsmedium nach Anspruch 19, bei dem das Verfahren des Bestimmens enthält:

ein Verfahren zum Optimieren der Anordnung der Bauteilzuführabschnitte (103a) durch Berücksichtigung von Positionsinformationen der Bestückungspunkte (173) und anschließend
ein Verfahren zum Optimieren des Bauteilbestückungsweges in dem dreidimensionalen Raum in der Weise, dass der Bestückungsweg bei der optimierten Anordnung der Bauteilzuführabschnitte (103a) am kürzesten wird.

21. Computerlesbares Aufzeichnungsmedium nach Anspruch 20, weiterhin enthaltend:

nach der Optimierung des Bauteilbestückungsweges ein Verfahren der Neuanordnung der Bauteilzuführabschnitte (103a),
ein Verfahren der nochmaligen Optimierung des Bauteilbestückungsweges unter Berücksichtigung der Neuanordnung der Bauteilzuführabschnitte (103a) und ein Verfahren zum Auswählen eines Bauteilbestückungsweges, der eine kürzere Bestückungsweglänge aufweist, durch Vergleichen zwischen der Situation vor und nach der Neuanordnung des Bauteilzuführabschnittes (103a).

22. Aufzeichnungsmedium nach Anspruch 20, bei dem das Optimierungsverfahren für die Anordnung des Bauteilzuführabschnittes (103a) enthält:

ein Verfahren zum temporären Anordnen de Bauteilzuführabschnitte (103a) und ein Verfahren zum Korrigieren der vorübergehenden Anordnung vor dem Optimierungsverfahren für den Bauteilbestückungsweg.

23. Aufzeichnungsmedium nach Anspruch 22, bei dem das Verfahren für die temporäre Anordnung bei dem Optimierungsverfahren für die Anordnung der Bauteilzuführabschnitte (103a) enthält:

ein Verfahren zum Bestimmen eines Produktes der Varianzen ($\sigma1$, $\sigma2$) jedes der X- und Y-Koordinatenwerte sowie der Z-Werte, die die Orte der Bauteilzuführabschnitte (103a) in Form von Bestückungspunkten (173) der Schaltungsplatine (2) wiedergeben, während der Z-Wert geändert wird, und ein Verfahren zum Bestimmen der Anordnung der Bauteilzuführabschnitte (103a) in der Weise, dass das Varianzprodukt ($\sigma1$, $\sigma2$) kleiner wird.

24. Aufzeichnungsmedium nach Anspruch 23, bei dem das Anordnungsverfahren zum Bestimmen des kleineren Varianzproduktes ($\sigma1$, $\sigma2$) enthält:

einen ersten Vorgang zum Bilden eines ersten Varianzproduktes für eine erste Anordnung der Bauteilzuführabschnitte (103a),
einen zweiten Vorgang zum Bilden eines zweiten Varianzproduktes für eine zweite Anordnung, die von der ersten Anordnung verschieden ist,
einen dritten Vorgang zum Vergleichen des ersten Varianzproduktes und des zweiten Varianzproduktes miteinander sowie zum Bestimmen des kleineren Varianzproduktes als das neue erste Varianzprodukt, und
einen Vorgang zum Bilden eines neuen, viel kleineren Varianzproduktes durch aufeinanderfolgendes Wiederholen des zweiten und des dritten Vorgangs.

25. Aufzeichnungsmedium nach Anspruch 22, bei dem das Korrekturverfahren für die temporäre Anordnung bei der Optimierung der Anordnung der Bauteilzuführabschnitte (103a) enthält:

einen Vorgang zum Ändern des Ortes eines zweiten Bauteilzuführabschnittes (103a-2) auf der Basis eines Abstandes zwischen einer Referenzbestückungsposition (178) auf der Schaltungsplatine (2), in der das Bauteil, welches von einem ersten Bauteilzuführabschnitt (103a-1) benachbart zu der Bauteilaufnahmeposition zugeführt wird, zu montieren ist, und einer Zielbestückungsposition (179) auf der Schaltungsplatine (2), in der das Bauteil, welches von dem zweiten Bauteilzuführabschnitt (103a-2) zugeführt wird, der ein anderer als der erste Bauteilzuführabschnitt (103a-1) ist, zu montieren ist, nachdem die Bauteilzuführabschnitte (103a) temporär durch Bestimmen des kleineren Varianzproduktes angeordnet wurden, wodurch die Anordnung der Bauteilzuführabschnitte (103a) weiter optimiert wird.

26. Aufzeichnungsmedium nach Anspruch 25, bei dem das Verfahren zum Ändern des Ortes des zweiten Bauteilzuführabschnittes (103a-2) enthält:

einen Vorgang zum Bestimmen jedes der Abstände, während der zweite Bauteilzuführabschnitt (103a-2) aufeinanderfolgend geändert wird, und zum Anordnen des zweiten Bauteilzuführabschnittes (103a-2), bei dem der Abstand am kürzesten ist, neben dem ersten Bauteilzuführabschnitt (103a-1).

27. Aufzeichnungsmedium nach Anspruch 20, bei dem das Optimierungsverfahren für den Bauteilbestückungsweg enthält:

einen Vorgang zum Auswählen zweier Bestückungswege zum Verbinden zweier Bestückungspunkte (173) unter den Bestückungswegen, zur Neukombinierung der beiden Bestückungswege und zum Auswählen des Weges, der eine kürzere Bestückungsweglänge besitzt, durch Vergleich zwischen der Situationen vor und nach der Neukombinierung, wodurch die Optimierung ausgeführt wird.

28. Bauteilbestückungsvorrichtung, enthaltend:

eine Bauteilzuführeinheit (103), die mehrere Zuführabschnitte (103a) zum Zuführen von Bauteilen enthält, die parallel angeordnet sind, um Bauteile aus einem der Zuführabschnitte, der in einer Bauteilaufnahmeposition (171) angeordnet ist, zuzuführen,
eine Bauteilverfahreinrichtung (105), die einen Bauteilhalter (105b) aufweist, um den Bauteilhalter zwischen der Bauteilaufnahmeposition (171) und einer Bauteilbestückungsposition (172) zu verfahren, um Bauteile (175), die von den Zuführabschnitten zugeführt werden, durch Bauteilhalter zu halten und
um die Bauteile an Bestückungspunkten (173) auf einer Schaltungsplatine (2) in der Bauteilbestückungsposition zu montieren,
mit einem Orthogonaltisch (109) zum Halten der Schaltungsplatine (2) und zum Bewegen der Schaltungsplatine (2) in die X- und Y-Achsenrichtung, wodurch die Bestückungspunkte (173) in der Bauteilbestückungsposition angeordnet werden, und
eine Steuereinrichtung (180) zum Optimieren des Vorgangs des Bestückungs der Schaltungsplatine mit Bauteilen aus den Zuführabschnitten, welche einen Anordnungs-Optimierungsabschnitt (181) für die Darstellung des Bestückungspunktes (173) in einem dreidimensionalen Raum, der **dadurch** gegeben ist, dass eine Z-Zahl, welche den Ort für jeden Bauteilzuführabschnitt (103a) wiedergibt, durch die Z-Achse und eine Ebene der Schaltungsplatine (2) durch die X- und Y-Achse ausgedrückt werden, und einen Bestückungsweg-Optimierungsabschnitt (182) zum Bestimmen einer Anordnung der Bauteilzuführabschnitte (103a) sowie einer Bauteilbestückungsfolge auf der Schaltungsplatine (2) in der Weise, dass ein Bauteilbestückungsweg, der die Bestückungspunkte (173) in dem dreidimensionalen Raum verbindet, den kleinsten Wert annimmt, enthält.

29. Bauteilbestückungsvorrichtung nach Anspruch 28, bei der der Anordnungs-Optimierungsabschnitt die Optimierung der Anordnung der Bauteilzuführabschnitte (103a) unter Berücksichtigung von Positionsinformationen der Bestückungspunkte (173) ausführt und der Bestückungsweg-Optimierungsabschnitt die Optimierung des Bauteilbestückungsweges in dem dreidimensionalen Raum in der Weise ausführt, dass der Bestückungsweg unter der optimierten Anordnung der Bauteilzuführabschnitte (103a) am kürzesten wird.

30. Bauteilbestückungsvorrichtung nach Anspruch 29, bei der der Bestückungsweg-Optimierungsabschnitt außerdem die Neuanordnung der Bauteilzuführabschnitte (103a) nach der Optimierung des Bauteilbestückungsweges, die nochmalige Optimierung des Bauteilbestückungsweges unter Berücksichtigung der Neuanordnung der Bauteilzuführabschnitte (103a) und das Auswählen eines Bauteilbestückungsweges, der eine kürzere Bestückungsweglänge aufweist, durch Vergleichen der Situation vor und nach der Neuanordnung der Bauteilzuführabschnitte (1 03a) ausführt.

31. Bauteilbestückungsvorrichtung nach Anspruch 28, bei der der Anordnungs-optimierungsabschnitt ein Produkt von drei Varianzen jedes der X- und Y-Koordinatenwerte und der Z-Werte, die die Orte der Zuführabschnitte wiedergeben, während der Z-Wert geändert wird, in Form von Bestückungspunkten (173) auf der Schaltungsplatine (2) bildet und die Anordnung der Bauteilzuführabschnitte (103a) bestimmt, welche das Varianzprodukt ($\sigma 1$, $\sigma 2$) kleiner werden lässt.

32. Bauteilbestückungsvorrichtung nach Anspruch 31, bei der der Anordnungs-optimierungsabschnitt die Anordnung bestimmt, die das Varianzprodukt ($\sigma 1$, $\sigma 2$) kleiner werden lässt, durch Bilden eines ersten Varianzproduktes für eine erste Anordnung der Zuführabschnitte, durch Bilden eines zweiten Varianzproduktes für eine zweite Anordnung, welche von der ersten Anordnung verschieden ist, durch Vergleichen des ersten Varianzproduktes und des zweiten Varianzproduktes miteinander, um das kleinere Varianzprodukt als neues erstes Varianzprodukt zu erhalten, und Bestimmen eines viel kleineren Varianzproduktes als ein neues erstes Varianzprodukt durch Wiederholen des Vergleiches.

33. Bauteilbestückungsvorrichtung nach Anspruch 31, bei der der Anordnungs-optimierungsabschnitt die Anordnung der Zuführabschnitte **dadurch** weiter optimiert, dass der Ort eines zweiten Zuführabschnitts (103a-2) auf Basis eines Abstandes zwischen einer Referenzbestückungsposition (178), in der das Bauteil, welches von einem ersten Bauteilzuführabschnitt (103a-1) benachbart zu der Bauteilaufnahmeposition zugeführt wird, zu montieren ist, und einer Zielbestückungsposition (179), in der das Bauteil zu montieren ist, welches von dem zweiten Zuführabschnitt (103a-2), bei dem es sich um einen anderen als den ersten Zuführabschnitt (103a-1) handelt, zugeführt wird, geändert wird, nachdem die Optimierung der Anordnung der Zuführabschnitte durch Bestimmen des kleineren Varianzproduktes erhalten worden ist.

**34.** Bauteilbestückungsvorrichtung nach Anspruch 33, bei der zum Ändern des Ortes des zweiten Zuführabschnittes (103a-2) der Abstand bestimmt wird, während der zweite Zuführabschnitt (103a-2) nachfolgend geändert wird, und der zweite Zuführabschnitt (103a-2), welcher den Abstand am kleinsten werden lässt, neben dem ersten Zuführabschnitt (103a-1) angeordnet wird.

**35.** Bauteilbestückungsvorrichtung nach Anspruch 28, bei der der Bestückungsweg-Optimierungsabschnitt durch Auswahl zweier Bestückungswege aus Bestückungswegen zum Verbinden zweier Bestückungspunkte (173), durch Neukombinierung der beiden Bestückungswege und durch Auswählen des Weges, der eine kürzere Bestückungsweglänge aufweist, durch Vergleich der Situation vor und nach der Neukombinierung optimiert.

**36.** Bauteilbestückungsvorrichtung nach Anspruch 35, bei der der Bestückungsweg-Optimierungsabschnitt eine Bestückungsfolge der Bestückungspunkte (173), welche einen neuen Bestückungsweg nach der Neukombinierung der Bestückungswege bilden, in Übereinstimmung mit dem neuen Bestückungsweg ändert.

## Revendications

**1.** Procédé d'optimisation d'ordre de montage de composants exécuté avant de réaliser d'une opération de montage de composants, dans lequel un composant est retenu à partir d'une partie d'approvisionnement en composants (103a) disposée à une position de détention des composants (171) parmi une pluralité de parties d'approvisionnement en composants (103a) agencées en parallèle et agencées de manière mobile pour fournir des composants, est transféré à une position de montage de composant (172), et est monté à un point de montage (173) sur une carte de circuit (2) disposée à la position de montage de composant par déplacement dans les directions de l'axe X et de l'axe Y, le procédé comprenant :

la représentation du point de montage (173) dans un espace tridimensionnel qui est donné en ce qu'un nombre Z représentant un emplacement de chaque partie d'approvisionnement en composants (103a) est exprimé par un axe Z et un plan de la carte de circuit (2) est exprimé par les axes X et Y ; et

la détermination d'un agencement des parties d'approvisionnement en composants (103a) et un ordre de montage des composants sur la carte de circuit (2) de sorte qu'un chemin de montage des composants reliant les points de montage (173) dans l'espace tridimensionnel devienne le plus court.

**2.** Procédé d'optimisation d'ordre de montage de composants selon la revendication 1, dans lequel l'opération de détermination comprend :

l'optimisation de l'agencement des parties d'approvisionnement en composants (103a) avec les informations de position des points de montage (173) pris en compte ; puis à

l'optimisation du chemin de montage des composants dans l'espace tridimensionnel de sorte que le chemin de montage devienne le plus court en fonction de l'agencement optimisé des parties d'approvisionnement en composants (103a).

**3.** Procédé d'optimisation d'ordre de montage de composants selon la revendication 2, comprenant en outre :

après l'optimisation du chemin de montage des composants, le réagencement des parties d'approvisionnement en composants (103a) ; l'optimisation du chemin de montage des composants de nouveau en fonction du réagencement des parties d'approvisionnement en composants (103a) ; et la sélection d'un chemin de montage des composants ayant une longueur de chemin de montage plus courte par comparaison entre avant et après le réagencement des parties d'approvisionnement en composants (103a).

**4.** Procédé d'optimisation d'ordre de montage de composants selon la revendication 2, dans lequel l'optimisation de l'agencement des parties d'approvisionnement en composants (103a) est réalisée en agençant temporairement les parties d'approvisionnement en composants (103a) et en corrigeant l'agencement provisoire avant l'optimisation du chemin de montage des composants.

**5.** Procédé d'optimisation d'ordre de montage de composants selon la revendication 4, dans lequel l'agencement provisoire dans l'optimisation de l'agencement des parties d'approvisionnement en composants (103a) est exécuté en obtenant un produit de variances ($\sigma1$, $\sigma2$) pour chacune des valeurs des coordonnées X et Y et des valeurs Z représentant les emplacements des parties d'approvisionnement en composants (103a) en termes des points de montage (173) de la carte de circuit (2) tandis que la valeur Z est modifiée, puis en obtenant l'agencement des parties d'approvisionnement en composants (103a) qui rend le produit de variances (σ1, σ2) plus petit.

6. Procédé d'optimisation d'ordre de montage de composants selon la revendication 5, dans lequel l'agencement qui rend le produit de variances (σ1, σ2) plus petit est obtenu en exécutant :

un premier processus consistant à obtenir un premier produit de variances pour un premier agencement des parties d'approvisionnement en composants (103a) ;
un deuxième processus consistant à obtenir un deuxième produit de variances pour un deuxième agencement différent du premier agencement ; et
un troisième processus consistant à comparer entre eux le premier produit de variances et le deuxième produit de variances et à définir le plus petit comme un nouveau premier produit de variances, obtenant ainsi un nouveau premier produit de variances beaucoup plus petit en répétant le deuxième processus et le troisième processus par la suite.

7. Procédé d'optimisation d'ordre de montage de composants selon la revendication 4, dans lequel, pour corriger l'agencement provisoire dans l'optimisation de l'agencement des parties d'approvisionnement en composants (103a), après que les parties d'approvisionnement en composants (103a) sont temporairement agencées en obtenant le produit de variances plus petit (σ1, σ2), l'emplacement d'une deuxième partie d'approvisionnement en composants (103a-2) est modifié sur la base d'une distance entre une position de montage de référence (178) sur la carte de circuit (2) où le composant fourni à partir d'une première partie d'approvisionnement en composants (103a-1) adjacente à la position de détention des composants (171) doit être monté et une position de montage d'objet (179) sur la carte de circuit (2) où le composant fourni à partir de la deuxième partie d'approvisionnement en composants (103a-2) autre que la première partie d'approvisionnement en composants (103a-1) doit être monté, optimisant ainsi encore l'agencement des parties d'approvisionnement en composants (103a).

8. Procédé d'optimisation d'ordre de montage de composants selon la revendication 7, dans lequel le changement de l'emplacement de la deuxième partie d'approvisionnement en composants (103a-2) comprend :

l'obtention de chacune des distances tandis que la deuxième partie d'approvisionnement en composants (103a-2) est modifiée séquentiellement ; et
l'agencement de la deuxième partie d'approvisionnement en composants (103a-2) qui réalise la distance la plus courte de façon à la rendre adjacente à la première partie d'approvisionnement en composants (103a-1).

9. Procédé d'optimisation d'ordre de montage de composants selon la revendication 2, dans lequel le chemin de montage de composants est optimisé en sélectionnant deux chemins de montage pour relier deux points de montage (173) parmi des chemins de montage, recombinant les deux chemins de montage, et sélectionnant le chemin ayant une longueur de chemin de montage plus courte par comparaison entre avant et après la recombinaison, exécutant ainsi l'optimisation.

10. Programme d'optimisation d'ordre de montage de composants pour faire exécuter à un ordinateur un procédé d'optimisation d'ordre de montage de composants dans une opération de montage de composants dans laquelle un composant est retenu à partir d'une partie d'approvisionnement en composants (103a) disposée à une position de détention des composants (171) parmi une pluralité de parties d'approvisionnement en composants (103a) agencées en parallèle et mobiles pour fournir des composants, est transféré à une position de montage de composant (172), et est monté à un point de montage (173) sur une carte de circuit (2) disposée à la position de montage de composant (172) par déplacement dans les directions d'axe X et d'axe Y, le programme comprenant :

une procédure consistant à représenter le point de montage (173) dans un espace tridimensionnel qui est donné de sorte qu'un nombre Z représentant un emplacement de chaque partie d'approvisionnement en composants (103a) est représenté par un axe Z et un plan de la carte de circuit (2) est représenté par les axes X et Y ; et
une procédure consistant à déterminer un agencement des parties d'approvisionnement en composants (103a) et un ordre de montage des composants sur la carte de circuit (2) de sorte qu'un chemin de montage des composants reliant les points de montage (173) dans l'espace tridimensionnel devienne le plus court.

11. Programme d'optimisation d'ordre de montage de composants selon la revendication 10, dans lequel la procédure de détermination consiste en :

une procédure consistant à optimiser l'agencement des parties d'approvisionnement en composants (103a) avec l'information de position des points de montage (173) prise en compte ; puis

une procédure consistant à optimiser le chemin de montage de composants dans l'espace tridimensionnel de sorte que le chemin de montage devienne le plus court en fonction de l'agencement optimisé des parties d'approvisionnement en composants (103a).

12. Programme d'optimisation d'ordre de montage de composants selon la revendication 11, comprenant en outre :

après l'optimisation du chemin de montage des composants, une procédure de réagencement des parties d'approvisionnement en composants (103a) ; une procédure consistant à optimiser de nouveau le chemin de montage de composants en fonction du réagencement des parties d'approvisionnement en composants (103a) ; et une procédure consistant à sélectionner un chemin de montage des composants ayant une longueur de chemin de montage plus courte par comparaison entre avant et après le réagencement des parties d'approvisionnement en composants (103a).

13. Programme d'optimisation d'ordre de montage de composants selon la revendication 11, dans lequel la procédure d'optimisation pour l'agencement des parties d'approvisionnement en composants (103a) comprend une procédure pour agencer temporairement les parties d'approvisionnement en composants (103a) et une procédure pour corriger l'agencement provisoire avant la procédure d'optimisation pour le chemin de montage de composants.

14. Programme d'optimisation d'ordre de montage de composants selon la revendication 13, dans lequel la procédure d'agencement provisoire dans la procédure d'optimisation pour l'agencement des parties d'approvisionnement en composants (103a) comprend une procédure consistant à obtenir un produit de variances ($\sigma1$, $\sigma2$) de chacune des valeurs de coordonnées X et Y et des valeurs Z indiquant des emplacements des parties d'approvisionnement en composants (103a) tandis que la valeur Z est modifiée en termes des points de montage (173) de la carte de circuit (2), et une procédure consistant à obtenir l'agencement des parties d'approvisionnement en composants (103a) qui rend le produit de variances ($\sigma1$, $\sigma2$) plus petit.

15. Programme d'optimisation d'ordre de montage de composants selon la revendication 14, dans lequel la procédure d'agencement consistant à rendre le produit de variances ($\sigma1$, $\sigma2$) plus petit comprend :

une première procédure consistant à obtenir un premier produit de variances pour un premier agencement des parties d'approvisionnement en composants (103a) ;
une deuxième procédure consistant à obtenir un deuxième produit de variances pour un deuxième agencement différent du premier agencement ;
une troisième procédure consistant à comparer entre eux le premier produit de variances et le deuxième produit de variances et à définir le plus petit comme un nouveau premier produit de variances ; et
une procédure consistant à obtenir un nouveau premier produit de variances beaucoup plus petit en répétant la deuxième procédure et la troisième procédure par la suite.

16. Programme d'optimisation d'ordre de montage de composants selon la revendication 13, dans lequel la procédure de correction pour l'agencement provisoire dans l'optimisation de l'agencement des parties d'approvisionnement en composants (103a) comprend, après que les parties d'approvisionnement en composants (103a) sont temporairement agencées en obtenant le produit de variances plus petit, une procédure consistant à modifier l'emplacement d'une deuxième partie d'approvisionnement en composants (103a-2) sur la base d'une distance entre une position de montage de référence (178) sur la carte de circuit (2) où le composant fourni à partir d'une première partie d'approvisionnement en composants (103a-1) adjacente à la position de détention des composants doit être montée et une position de montage d'objet (179) sur la carte de circuit (2) où le composant fourni à partir de la deuxième partie d'approvisionnement en composants (103a-2) autre que la première partie d'approvisionnement en composants (103a-1) doit être monté, optimisant ainsi encore l'agencement des parties d'approvisionnement en composants (103a).

17. Programme d'optimisation d'ordre de montage de composants selon la revendication 16, dans lequel la procédure consistant à modifier l'emplacement de la deuxième partie d'approvisionnement en composants (103a-2) comprend une procédure consistant à obtenir chacune des distances tandis que la deuxième partie d'approvisionnement en composants (103a-2) est modifiée séquentiellement, et à agencer la deuxième partie d'approvisionnement en composants (103a-2) qui réalise la distance la plus courte de façon à être adjacente à la première partie d'approvisionnement en composants (103a-1).

**18.** Programme d'optimisation d'ordre de montage de composants selon la revendication 11, dans lequel la procédure d'optimisation pour le chemin de montage de composants comprend une procédure consistant à sélectionner deux parmi les chemins de montage pour relier deux points de montage (173), recombiner les deux chemins de montage et sélectionner le chemin ayant une longueur de chemin de montage plus courte par comparaison entre avant et après la recombinaison, exécutant ainsi l'optimisation.

**19.** Support d'enregistrement lisible par ordinateur sur lequel est stocké un programme selon la revendication 10.

**20.** Support d'enregistrement lisible par ordinateur selon la revendication 19, dans lequel la procédure de détermination a :

une procédure consistant à optimiser l'agencement des parties d'approvisionnement en composants (103a) avec l'information de position des points de montage (173) prise en compte ; et puis
une procédure consistant à optimiser le chemin de montage de composants dans l'espace tridimensionnel de sorte que le chemin de montage devienne le plus court en fonction de l'agencement optimisé des parties d'approvisionnement en composants (103a).

**21.** Support d'enregistrement lisible par ordinateur selon la revendication 20, comprenant en outre :

après l'optimisation du chemin de montage des composants, une procédure consistant à réagencer les parties d'approvisionnement en composants (103a) ;
une procédure consistant à optimiser le chemin de montage de composants de nouveau en fonction du réagencement des parties d'approvisionnement en composants (103a) ; et une procédure consistant à sélectionner un chemin de montage des composants ayant une longueur de chemin de montage plus courte par comparaison entre avant et après le réagencement des parties d'approvisionnement en composants (103a).

**22.** Support d'enregistrement selon la revendication 20, dans lequel la procédure d'optimisation pour l'agencement des parties d'approvisionnement en composants (103a) comprend une procédure consistant à agencer temporairement les parties d'approvisionnement en composants (103a) et une procédure consistant à corriger l'agencement provisoire avant la procédure d'optimisation pour le chemin de montage de composants.

**23.** Support d'enregistrement selon la revendication 22, dans lequel la procédure d'agencement provisoire dans la procédure d'optimisation pour l'agencement des parties d'approvisionnement en composants (103a) comprend une procédure consistant à obtenir un produit de variances ($\sigma1$, $\sigma2$) de chacune des valeurs de coordonnées X et Y et des valeurs Z représentant les emplacements des parties d'approvisionnement en composants (103a) tandis que la valeur Z est modifiée en termes des points de montage (173) de la carte de circuit (2), et une procédure consistant à obtenir l'agencement des parties d'approvisionnement en composants (103a) qui rend le produit de variances ($\sigma1$, $\sigma2$) plus petit.

**24.** Support d'enregistrement selon la revendication 23, dans lequel la procédure d'agencement consistant à rendre le produit de variances ($\sigma1$, $\sigma2$) plus petit comprend :

une première procédure consistant à obtenir un premier produit de variances pour un premier agencement des parties d'approvisionnement en composants (103a) ;
une deuxième procédure consistant à obtenir un deuxième produit de variances pour un deuxième agencement différent du premier agencement ;
une troisième procédure consistant à comparer entre eux le premier produit de variances et le deuxième produit de variances et à définir le plus petit comme un nouveau premier produit de variances ; et
une procédure consistant à obtenir un nouveau premier produit de variances beaucoup plus petit en répétant la deuxième procédure et la troisième procédure par la suite.

**25.** Support d'enregistrement selon la revendication 22, dans lequel la procédure de correction pour l'agencement provisoire dans l'optimisation de l'agencement des parties d'approvisionnement en composants (103a) comprend, après que les parties d'approvisionnement en composants (103a) sont temporairement agencées en obtenant le produit de variances plus petit, une procédure consistant à modifier l'emplacement d'une deuxième partie d'approvisionnement en composants (103a-2) sur la base d'une distance entre une position de montage de référence (178) sur la carte de circuit (2) à laquelle le composant fourni à partir d'une première partie d'approvisionnement en composants (103a-1) adjacente à la position de détention des composants doit être montée et une position de

27

montage d'objet (179) sur la carte de circuit (2) à laquelle le composant fourni à partir de la deuxième partie d'approvisionnement en composants (103a-2) autre que la première partie d'approvisionnement en composants (103a-1) doit être monté, optimisant ainsi encore l'agencement des parties d'approvisionnement en composants (103a).

26. Support d'enregistrement selon la revendication 25, dans lequel la procédure consistant à modifier l'emplacement de la deuxième partie d'approvisionnement en composants (103a-2) comprend une procédure consistant à obtenir chacune des distances tandis que la deuxième partie d'approvisionnement en composants (103a-2) est modifiée séquentiellement, et à agencer la deuxième partie d'approvisionnement en composants (103a-2) qui réalise la distance la plus courte de façon à être adjacente à la première partie d'approvisionnement en composants (103a-1).

27. Support d'enregistrement selon la revendication 20, dans lequel la procédure d'optimisation pour le chemin de montage de composants comprend une procédure consistant à sélectionner deux parmi les chemins de montage pour relier deux points de montage (173), recombiner les deux chemins de montage et sélectionner le chemin ayant une longueur de chemin de montage plus courte par comparaison entre avant et après la recombinaison, exécutant ainsi l'optimisation.

28. Dispositif de montage de composants comprenant :

une unité d'approvisionnement en composants (103) ayant une pluralité de parties d'approvisionnement (103a) disposées en parallèle pour fournir des composants, pour fournir des composants à partir d'une des parties d'approvisionnement placées à une position de détention des composants (171) ;
un dispositif de déplacement de composant (105) ayant un support de composant (105b), pour transférer le support de composant entre la position de détention des composants (171) et une position de montage de composant (172), maintenant les composants (175) fournis à partir des parties d'approvisionnement par les supports de composants, et montant les composants aux points de montage (173) sur une carte de circuit (2) à la position de montage des composants ;
une table orthogonale (109) pour tenir la carte de circuit (2) et déplacer la carte de circuit (2) dans les directions d'axes X et Y, localisant ainsi les points de montage (173) à la position de montage du composant ; et
un contrôleur (180) pour optimiser une opération de montage des composants sur la carte de circuit (2) à partir des parties d'approvisionnement, qui comprend une partie d'optimisation d'agencement (181) pour représenter le point de montage (173) dans un espace tridimensionnel qui est donné de sorte qu'un nombre Z représentant un emplacement de chaque partie d'approvisionnement en composants (103a) est représenté par un axe Z, et un plan de la carte de circuit (2) est représenté par les axes X et Y, et une partie d'optimisation de chemin de montage (182) pour déterminer un agencement des parties d'approvisionnement en composants (103a) et un ordre de montage des composants sur la carte de circuit (2) de sorte qu'un chemin de montage des composants reliant les points de montage (173) dans l'espace tridimensionnel devienne le plus court.

29. Dispositif de montage de composants selon la revendication 28, dans lequel la partie d'optimisation d'agencement réalise une optimisation de l'agencement des parties d'approvisionnement en composants (103a) avec l'information de position des points de montage (173) prise en compte, et la partie d'optimisation de chemin de montage réalise l'optimisation du chemin de montage des composants dans l'espace tridimensionnel de sorte que le chemin de montage devienne le plus court en fonction de l'agencement optimisé des parties d'approvisionnement en composants (103a).

30. Dispositif de montage de composants selon la revendication 29, dans lequel la partie d'optimisation de chemin de montage réalise en outre le réagencement des parties d'approvisionnement en composants (103a) après l'optimisation du chemin de montage des composants, l'optimisation du chemin de montage des composants de nouveau en fonction du réagencement des parties d'approvisionnement en composants (103a), et la sélection d'un chemin de montage des composants ayant une longueur de chemin de montage plus courte par comparaison entre avant et après le réagencement des parties d'approvisionnement en composants (103a).

31. Dispositif de montage de composants selon la revendication 28, dans lequel la partie d'optimisation de l'agencement obtient un produit de trois variances de chacune des valeurs de coordonnées X et Y et des valeurs Z représentant les emplacements des parties d'approvisionnement en composants tandis que la valeur Z est modifiée en termes de points de montage (173) sur la carte de circuit (2), et obtient l'agencement des parties d'approvisionnement en composants (103a) qui rend le produit de variances ($\sigma 1$, $\sigma 2$) plus petit.

**32.** Dispositif de montage de composants selon la revendication 31, dans lequel la partie d'optimisation de l'agencement obtient l'agencement qui rend le produit de variances ($\sigma 1$, $\sigma 2$) plus petit en obtenant un premier produit de variances pour un premier agencement des parties d'approvisionnement, obtenant un deuxième produit de variances pour un deuxième agencement différent du premier agencement ; en comparant entre eux le premier produit de variances et le deuxième produit de variances pour définir le plus petit comme un nouveau premier produit de variances, et en obtenant un produit de variances beaucoup plus petit comme un nouveau premier produit de variances en répétant la comparaison.

**33.** Dispositif de montage de composants selon la revendication 31, dans lequel la partie d'optimisation de l'agencement optimise encore l'agencement des parties d'approvisionnement, après avoir optimisé l'agencement des parties d'approvisionnement en obtenant le produit de variances plus petit, causé en modifiant un emplacement d'une deuxième partie d'approvisionnement (103a-2) sur la base d'une distance entre une position de montage de référence (178) à laquelle le composant fourni à partir d'une première partie d'approvisionnement (103a-1) adjacente à la position de détention des composants doit être monté et une position de montage d'objet (179) à laquelle le composant fourni à partir de la deuxième partie d'approvisionnement (103a-2) autre que la première partie d'approvisionnement (103a-1) doit être monté.

**34.** Dispositif de montage de composants selon la revendication 33, dans lequel pour modifier l'emplacement de la deuxième partie d'approvisionnement (103a-2), la distance est obtenue tandis que la deuxième partie d'approvisionnement (103a-2) est modifiée séquentiellement et la deuxième partie d'approvisionnement (103a-2) qui rend la distance la plus courte est disposée adjacente à la première partie d'approvisionnement (103a-1).

**35.** Dispositif de montage de composants selon la revendication 28, dans lequel la partie d'optimisation de chemin de montage optimise en choisissant deux parmi les chemins de montage pour relier deux points de montage (173), en recombinant les deux chemins de montage, et en sélectionnant le chemin ayant une longueur de chemin de montage plus courte par comparaison entre avant et après la recombinaison.

**36.** Dispositif de montage de composants selon la revendication 35, dans lequel la partie d'optimisation de chemin de montage modifie un ordre de montage de points de montage (173) qui constituent un nouveau chemin de montage après la recombinaison de chemins de montage, conformément au nouveau chemin de montage.

## Fig. 1

START

S100    TO DETERMINE INITIAL ARRANGEMENT OF COMPONENT CASSETTES

S200    TO CORRECT COMPONENT CASSETTES ARRANGEMENT DETERMINED IN STEP S100

S300    TO OBTAIN SHORTEST PATH FOR CONNECTING TWO-DIMENSIONAL MOUNTING POINTS

S400    TO SELECT AND REARRANGE ARBITRARY TWO CASSETTES FROM PRESENT ARRANGEMENT. (TO RETURN TO STEP 300 TO OBTAIN MOUNTING PATH AND THEN ADVANCE TO STEP 400, TO OBTAIN BETTER MOUNTING PATH BY REPEATING THIS PROCESS)

END

*Fig. 2*

*Fig. 3*

*Fig. 4*

*Fig. 6*

## *Fig. 5*

S 1 0 1      TO PROVIDE INITIAL ARRANGEMENT

S 1 0 2      TO SUBSTITUTE 0 FOR NUMBER OF CHANGEOVER TIMES OF z-COORDINATE

S 1 0 3      TO CALCULATE AND SUBSTITUTE VARIANCE DETERMINANT VALUE FOR Dold

S 1 0 4      TO SELECT TWO Z-PLANES AT RANDOM WITH USE OF RANDOM NUMBERS

S 1 0 5      TO CHANGE OVER SELECTED TWO Z-PLANES

S 1 0 6      TO CALCULATE AND SUBSTITUTE VARIANCE DETERMINANT VALUE FOR Dnew

S 1 0 7      TO COMPARE Dold AND Dnew WITH EACH OTHER

S 1 0 8      TO STORE COMPONENT CASSETTES ARRANGEMENT AFTER CHANGEOVER WHEN VARIANCE DETERMINANT VALUE Dnew AFTER CHANGEOVER IS SMALLER, OR TO RETURN TO STATE OF COMPONENT CASSETTES ARRANGEMENT BEFORE CHANGEOVER WHEN VARIANCE DETERMINANT VALUE Dnew AFTER CHANGEOVER IS LARGER

S 1 0 9      TO ADD 1 INTO NUMBER OF CHANGEOVER TIMES AND THEN RETURN TO STEP 105 AND REPEAT THE PROCESS UNTIL THE NUMBER REACHES FIXED NUMBER OF TIMES, TO TERMINATE THE PROCESS WHEN THE NUMBER REACHES FIXED NUMBER OF TIMES

S 1 1 0      TO STORE COMPONENT CASSETTES ARRANGEMENT AT THIS TIME (ARRANGEMENT OF Z-PLANES) AS TEMPORARY OPTIMUM COMPONENT CASSETTES ARRANGEMENT

## Fig. 7

$$\text{START}$$

**S201** — TO CHECK FROM Z=0 WHETHER z-PLANE INCLUDES ONE OR TWO MOUNTING POINTS. TO ADVANCE THE PROCESS WHEN THE PLANE INCLUDES MOUNTING POINTS. TO CHANGE Z TO Z=+1 UNLESS THE PLANE INCLUDES MOUNTING POINTS AND TO CHECK SIMILARLY WHETHER Z-PLANE INCLUDES ONE OR TWO MOUNTING POINTS

**S202** — TO SET z OBTAINED IN STEP 202 AS REFERENCE z1

**S203** — TO SELECT MOUNTING POINT INCLUDED IN z1 AS REFERENCE MOUNTING POSITION

**S204** — TO CHECK FROM Z=Zn/2 WHETHER z-PLANE INCLUDES ONE OR TWO MOUNTING POINTS. TO FOLLOW THE PROCESS WHEN THE PLANE INCLUDES MOUNTING POINTS, TO SUBTRACT 1 FROM Z UNLESS THE PLANE INCLUDES MOUNTING POINTS AND TO CHECK SIMILARLY WHETHER z-PLANE INCLUDES ONE OR TWO MOUNTING POINTS

**S205** — TO SET Z OBTAINED IN STEP 204 AS OBJECT z2

**S206** — TO SELECT MOUNTING POINT INCLUDED IN z2 AS OBJECT MOUNTING POSITION

**S207** — TO CALCULATE X,Y-DISTANCE BETWEEN z1 AND z2 MOUNTING POINTS. TO ADD X,Y-DISTANCE BETWEEN TWO MOUNTING POINTS ON THE SAME z-PLANE WHEN THE PLANE INCLUDES THE TWO MOUNTING POINTS

**S208** — TO COMPARE DISTANCE WITH A PREVIOUS VALUE AND STORE THE DISTANCE AS L WHEN IT IS SMALLER, TO SUBTRACT 1 FROM Z AND TO RETURN TO STEP 204, TO PROCEED TO NEXT STEP WHEN z2 REACHES z1

**S209** — TO MOVE Z2 WHICH PROVIDES SMALLEST L TO POSITION OF z1+1, TO MOVE ORIGINAL Zs AFTER Z1+1 BACKWARDS EACH BY ONE, TO RETURN TO STEP 201

**S210** — TO TERMINATE THE PROCESS WHEN z1 REACHES Zn/2

$$\text{END}$$

*Fig. 8*

*Fig. 15*

## Fig. 9

START

S301 — TO PROVIDE INITIAL MOUNTING ORDER 01

S302 — TO OBTAIN INITIAL MOUNTING PATH P1 ON THE BASIS OF INITIAL MOUNTING ORDER 01 AND INITIAL COMPONENT CASSETTES ARRANGEMENT Z01

S303 — TO CALCULATE MOUNTING PATH LENGTH OF INITIAL MOUNTING PATH P1 AND TO SUBSTITUTE INITIAL MOUNTING PATH P1 AND MOUNTING PATH LENGTH FOR MOUNTING PATH P AND OPTIMUM MOUNTING PATH LENGTH Lopt RESPECTIVELY

S304 — TO SUBSTITUTE INITIAL MOUNTING ORDER 01 FOR MOUNTING ORDER 0 AND OPTIMUM MOUNTING ORDER Oopt

S305 — TO SUBSTITUTE INITIAL COMPONENT CASSETTES ARRANGEMENT Z01 FOR COMPONENT CASSETTES ARRANGEMENT Z0 AND OPTIMUM COMPONENT CASSETTES ARRANGEMENT Z0opt

S306 — TO SUBSTITUTE 0 FOR NUMBER OF RECOMBINATION TIMES (a)

S307 — TO OBTAIN NEW MOUNTING ORDER Onew (NEW MOUNTING PATH Pnew) WITH USE OF RECOMBINATION METHOD FOR OPTIMIZING MOUNTING ORDER 0 (AS WELL AS MOUNTING PATH P AT THE SAME TIME)

TO STEP 400

## Fig. 10

```
                        ( START )
                            |
S320    ┌─────────────────────────────────────────┐
        │   TO SET i TO FIRST MOUNTING POINT (i=1) │
        │        IN INITIAL MOUNTING ORDER         │
        └─────────────────────────────────────────┘
                            |
S321    ┌─────────────────────────────────────────┐
        │  TO SET j TO j=i+1 IN INITIAL MOUNTING ORDER │
        └─────────────────────────────────────────┘
                            |
        ┌─────────────────────────────────────────┐
        │   TO SELECT UNIT PATHS u (i, iBottom) AND u │
        │   (j, jBottom) FOR CONNECTING TWO SELECTED │
        │   MOUNTING POINTS WITH TWO MOUNTING POINTS │
S322    │  iBottom AND jBottom TO BE MOUNTED NEXT TO THE │
        │   SELECTED MOUNTING POINTS RESPECTIVELY AS │
        │          OBJECTS OF RECOMBINATION         │
        └─────────────────────────────────────────┘
                            |
        ┌─────────────────────────────────────────┐
        │   TO CALCULATE SUM OF PRESENT LENGTHS OF TWO │
        │      UNIT PATHS SELECTED AS OBJECTS OF    │
S323    │  RECOMBINATION FROM VALUES OBTAINED IN STEP │
        │     302 AND TO STORE THE SUM INTO Dorg    │
        └─────────────────────────────────────────┘
                            |
        ┌─────────────────────────────────────────┐
        │   TO CALCULATE UNIT PATH LENGTH AFTER     │
        │  RECOMBINATION FROM VALUES OBTAINED IN STEP │
S324    │  302 BEFORE UNIT PATHS SELECTED AS OBJECTS OF │
        │  RECOMBINATION ARE ACTUALLY RECOMBINED AND TO │
        │  SUBSTITUTE THE UNIT PATH LENGTH FOR Dpara │
        └─────────────────────────────────────────┘
```

(IV)          (I)          (II)

(III)

37

# Fig. 11

S325

S326 — TO COMPARE Dorg AND Dpara WITH EACH OTHER

TO ACTUALLY RECOMBINE UNIT PATHS ONLY WHEN Dpara IS SMALLER TO FORM MOUNTING PATH BY NEW UNIT PATHS u (i, j) AND u (iBottom, jBottom) AND TO REFLECT THE OPTIMIZED MOUNTING PATH TO MOUNTING ORDER

S327 — TO ADD i TO j AND THEN RETURN TO STEP 322 WHEN j IS SMALLER THAN (TOTAL NUMBER OF MOUNTING POINTS-1) OR TO MOVE TO NEXT STEP WHEN j IS LARGER THAN (TOTAL NUMBER OF MOUNTING POINTS-1)

S328 — TO ADD 1 TO i AND THEN RETURN TO STEP 321 WHEN i IS SMALLER THAN (TOTAL NUMBER OF MOUNTING POINTS-2) OR TO MOVE TO NEXT STEP WHEN i IS LARGER THAN (TOTAL NUMBER OF MOUNTING POINTS-2)

S329 — TO CALCULATE TOTAL MOUNTING PATH LENGTH L

S330 — TO COMPARE Lopt AND L WITH EACH OTHER TO TERMINATE THE PROCESS WHEN BOTH AGREE OR TO RETURN TO STEP 320 IN OTHER CASES WITH 1 ADDED TO (a) TO END WHEN (a) EXCEEDS FIXED NUMBER OF TIMES

*Fig. 12*

173-5

jBottom

173-3

173-1　173-2

173-4

j
iBottom

i

*Fig. 13*

173-5

j

173-3

173-1　173-2

173-4
jBottom

iBottom

i

*Fig. 14*

jBottom
5

3

1　2

j
4

iBottom

i

*Fig. 16*

*Fig. 17*

*Fig. 18*

| MOUNTING ORDER | MOUNTING POINT |
|---|---|
| N o 1 | 1 7 3-1 |
| N o 2 | 1 7 3-2 |
| N o 3 | 1 7 3-7 |
| N o 4 | 1 7 3-6 |
| N o 5 | 1 7 3-5 |
| N o 6 | 1 7 3-4 |
| N o 7 | 1 7 3-3 |
| N o 8 | 1 7 3-8 |
| N o 9 | 1 7 3-9 |

## *Fig. 19*

```
                    ┌─────────────────────┐
                    │   START  STEP  400   │
                    └─────────────────────┘
                              │          ◄──────────── Ⓥⓘ
        ┌──────────────────────────────────────────────┐
        │     TO SELECT TWO FROM COMPONENT CASSETTES    │
S401    │   ARRANGEMENT AT RANDOM WITH USE OF RANDOM    │
        │    VALUES AND TO REARRANGE THE SELECTED       │
        │             COMPONENT CASSETTES               │
        └──────────────────────────────────────────────┘
        ┌──────────────────────────────────────────────┐
        │   TO SUBSTITUTE MOUNTING ORDER O FOR OPTIMUM  │
        │  MOUNTING ORDER Oopt AND COMPONENT CASSETTES  │
S402    │     ARRANGEMENT ZO FOR OPTIMUM COMPONENT      │
        │          CASSETTES ARRANGEMENT ZOopt          │
        └──────────────────────────────────────────────┘
        ┌──────────────────────────────────────────────┐
        │    TO RETURN TO STEP 307 TO REPEAT THE PROCESS│
        │    UNTIL NUMBER OF REARRANGEMENT TIMES (a)     │
S403    │   REACHES FIXED NUMBER OF TIMES,TO TERMINATE  │
        │    THE PROCESS WHEN NUMBER OF REARRANGEMENT   │
        │    TIMES (a) REACHES FIXED NUMBER OF TIMES    │
        └──────────────────────────────────────────────┘
        ┌──────────────────────────────────────────────┐
S404    │  TO CALCULATE MOUNTING PATH LENGTH Lnew OF NEW│
        │             MOUNTING PATH Pnew                │
        └──────────────────────────────────────────────┘
                              │
                              Ⓥ
```

*Fig. 20*

(V)

**S 4 0 5**
TO COMPARE PRESENT OPTIMUM
MOUNTING PATH LENGTH Lopt WITH
NEW MOUNTING PATH LENGTH Lnew

WHEN Lopt IS
SMALLER

WHEN Lnew IS
SMALLER

**S 4 0 6**

TO DISCARD MOUNTING ORDER
Onew, COMPONENT CASSETTES
ARRANGEMENT ZO AND NEW
MOUNTING PATH LENGTH Lnew

**S 4 0 7**

TO SUBSTITUTE MOUNTING ORDER Onew
FOR OPTIMUM MOUNTING ORDER Oopt,
COMPONENT CASSETTES ARRANGEMENT
ZO FOR OPTIMUM COMPONENT
CASSETTES ARRANGEMENT ZOOPT AND
NEW MOUNTING PATH LENGTH Lnew FOR
OPTIMUM MOUNTING PATH LENGTH Lopt

**S 4 0 8**
ARE COMPONENT
CASSETTES REARRANGED
BY SET NUMBER OF
TIMES?

NO — (VI)

YES

**S 4 0 9**
TO STORE OPTIMUM COMPONENT CASSETTES
ARRANGEMENT (ARRANGEMENT OF Z-PLANE) AND
OPTIMUM MOUNTING ORDER Oopt AT THIS TIME AS
OPTIMUM COMPONENT CASSETTES ARRANGEMENT AND
OPTIMUM MOUNTING ORDER RESPECTIVELY

( END )

## Fig.21

EP 1 527 664 B1

*Fig. 22*

*Fig. 23*

*Fig. 25*

|  | XY MOVEMENT DISTANCE | THREE-DIMENSIONAL MOVEMENT DISTANCE | TOTAL NUMBER OF Z SHIFT |
|---|---|---|---|
| PRESENT EMBODIMENT | 3644 | 5619 | 133 |
| A | 4002 | 5816 | 115 |
| B | 5193 | 7372 | 165 |

*Fig. 24*

STORAGE — 185

186

ARRANGEMENT OPTIMIZING PART | MOUNTING PATH OPTIMIZING PART

TO READ ← 

180

181    182

187

COMPONENT SUPPLY UNIT — 103

COMPONENT SHIFT DEVICE — 105

CIRCUIT BOARD TRANSFER DEVICE — 118

COMPONENT RECOGNIZER — 111

ORTHOGONAL TABLE — 109

Fig.26

Y ↑ → X

EP 1 527 664 B1

47

# Fig. 27